# EUROPEAN PATENT APPLICATION

(11) **EP 4 733 951 A1**
(43) Date of publication of application: **29.04.2026**
(21) Application number: 24850500.0
(22) Date of filing: 15.03.2024
(51) Int. Cl.: G06F 16/22

(54) **DATA PROCESSING METHOD AND RELATED DEVICE**

(30) Priority: 04.08.2023 CN 202310983845; 25.08.2023 CN 202311086568
(71) Applicant: Huawei Technologies Co., Ltd., Shenzhen, Guangdong 518129 (CN)
(72) Inventor: ZHANG, Gong, Shenzhen, Guangdong 518129 (CN); YAO, Xin, Shenzhen, Guangdong 518129 (CN); CHEN, Renhai, Shenzhen, Guangdong 518129 (CN); HUANG, Keji, Shenzhen, Guangdong 518129 (CN)
(74) Representative: Huawei European IPR
(86) International application number: PCT/CN2024/081945
(87) International publication number: WO 2025/030840

(57) **Abstract**

This application discloses a data processing method and a related device, to resolve a problem of low indexing efficiency of an index structure. The method includes: obtaining an operation request, where the operation request includes an operation instruction and to-be-operated data; performing product quantization encoding on a target residual value or the to-be-operated data to obtain a target key, where the target residual value is a residual value between the to-be-operated data and a centric vector of a target data group, and the target data group is a data group to which the to-be-operated data belongs in K data groups; and executing the operation instruction based on the target key and a target learned index corresponding to the target data group.

## Description

This application claims priorities to Chinese Patent Application No. 202310983845.6, filed with the China National Intellectual Property Administration on August 4, 2023 and entitled "DATA PROCESSING METHOD", and to Chinese Patent Application No. 202311086568.5, filed with the China National Intellectual Property Administration on August 25, 2023 and entitled "DATA PROCESSING METHOD AND RELATED DEVICE", both of which are incorporated herein by reference in their entireties.

### TECHNICAL FIELD

This application relates to the field of storage technologies, and in particular, to a data processing method and a related device.

### BACKGROUND

In the era of big data and cloud computing, how to quickly query and update data in a large-scale database is one of main indicators for measuring performance of the large-scale database.

With development and wide application of internet technologies, an amount of data increases explosively. However, it is difficult for an existing structured data database technology to maintain an amount of data of a sufficient scale. In addition to a data object, a structured data representation of the data object becomes a new type of metadata storage, and brings great storage overheads and computing pressure to a storage system. Two major problems need to be resolved in a structured data database: The first one is efficient query, and the second one is efficient analysis and storage.

A product quantization (product quantization, PQ) algorithm is a query algorithm proposed to improve a retrieval speed. In the PQ, long structured data is first divided into m subspaces by using a division method, and approximate structured data is classified into a same cluster by using a K-Means clustering method in each subspace. Structured data in each centric point is organized and stored through inverted indexing. During query, a corresponding centric point is found first based on structured data for querying, then all neighboring elements are found in inverted indexes, and top-K approximate elements are found using a distance calculation function. When an inverted indexing design is used for management of big data, indexes occupies a large storage space, and index search efficiency is low (applicable to a query of top-K approximate images, where one query takes about 100 µs).

### SUMMARY

This application provides a data processing method, to resolve a problem of low query efficiency of a current index structure.

According to a first aspect, this application provides a data processing method. The method may be applied to a computing device, for example, a computer, a server, a mobile phone, an intelligent network interface card, or a programmable switch. The method includes: obtaining an operation request, where the operation request includes an operation instruction and to-be-operated data; performing product quantization encoding on a target residual value or the to-be-operated data to obtain a target key, where the target residual value is a residual value between the to-be-operated data and a centric vector of a target data group, the target data group is a data group to which the to-be-operated data belongs in K data groups, and K is an integer greater than or equal to 1; and executing the operation instruction based on the target key and a target learned index corresponding to the target data group.

Compared with a conventional index structure, a learned index structure is more lightweight, and can reduce a quantity of data queries and improve query efficiency while reducing an occupied storage space. Further, in this application, product quantization compression is further performed on to-be-processed data, to reduce a space occupied by a key in an index structure, and further reduce a storage space occupied by the index structure.

In a possible implementation, the K data groups are obtained by clustering data in a data set, each data group includes data aggregated through clustering, and the data in the data groups does not overlap. Approximate data in the data set is clustered into a same data group, so that data distribution in the data group is approximately consistent. In this case, a learned index corresponding to each data group can learn a data distribution rule in the data group more accurately, to improve accuracy of a position predicted by the learned index.

In a possible implementation, the target learned index is used to output, based on the target key, a pointer corresponding to the to-be-operated data, the target learned index includes a learned index model and a mapping unit, the learned index model is used to output, based on the target key, a target position of the target key in the mapping unit, and a mapping relationship between the target key and the pointer corresponding to the to-be-operated data is stored at the target position.

A target learned index model learns a distribution rule of target keys in the mapping unit, and actual data distribution in a storage medium is decoupled from the target learned index model. In this case, when the data is written into the storage medium, whether the data writing affects the data distribution rule in the storage medium does not need to be considered. The data may be written into the storage medium through appending, so that write performance can be improved. In addition, during data query, a position of the target key in the mapping unit can be quickly hit through the target learned index model, so that a quantity of queries can be reduced. The mapping unit stores a mapping relationship between the target key and the pointer. A storage position of corresponding data can be accurately obtained, thereby improving query accuracy and efficiency.

In a possible implementation, a target learned index model includes a root model, at least two intermediate models, and at least two leaf models, the root model is used to select a target intermediate model from the at least two intermediate models based on the target key, the target intermediate model is used to select a target leaf model from the at least two leaf models, the target leaf model is used to output the target position based on the target key, and the target leaf model is a non-linear function. The non-linear function can better fit key distribution, to predict a position of a key more accurately.

In a possible implementation, at least a part of the learned index model is stored in a storage corresponding to an external computing device, and the external computing device is configured to obtain the target intermediate model, the target leaf module, or the target position based on the at least part of the model. A part of query operations are offloaded to the external computing device, so that query efficiency can be improved. The external computing device may be an intelligent chip, a graphics processing unit, an intelligent network interface card, a programmable switch, or the like.

In a possible implementation, the operation instruction is a query instruction, the query instruction instructs to read target data corresponding to the to-be-operated data, and the executing the operation instruction based on the target key and the target learned index corresponding to the target data group includes: obtaining a first pointer through the target learned index based on the target key, where the first pointer indicates a storage position of the target data; and obtaining the target data based on the first pointer, where when the first pointer is associated with one piece of data, the target data is the data associated with the first pointer; or when the first pointer is associated with multiple pieces of data, the target data is data that has a smallest distance from the to-be-operated data in the multiple pieces of data associated with the first pointer. Data query efficiency can be improved through the target learned index.

In a possible implementation, the target data is stored as compressed target data after compression, and the obtaining the target data based on the first pointer includes: obtaining the compressed target data based on the first pointer; and decompressing the compressed target data via a decoder, to obtain the target data, where the target data is structured data, the target data includes N data segments obtained through division based on an attribute, the compressed target data includes N compressed data segments, the N compressed data segments are obtained by compressing the N data segments via M sub-encoders of an encoder, each of the sub-encoders is configured to encode at least one data segment corresponding to one attribute, the decoder includes M sub-decoders, the M sub-decoders are in one-to-one correspondence with the M sub-encoders, and each of the sub-decoders is configured to decode at least one of the N compressed data segments. Data is compressed based on a structure of the data, so that a compression ratio of the data can be improved, and a storage space occupied by the data can be reduced. Both M and N are integers greater than or equal to 1.

In a possible implementation, the operation instruction is an update instruction, and the executing the operation instruction based on the target key and the target learned index corresponding to the target data group includes: obtaining, through the target learned index based on the target key, a corresponding second pointer indicating the target key; and writing the to-be-operated data into a storage medium based on the second pointer.

In a possible implementation, the operation instruction is an update instruction, and the executing the operation instruction based on the target key and the target learned index corresponding to the target data group includes: writing the to-be-operated data into a storage medium; and updating the target learned index with a mapping relationship between the target key and a second pointer, where the second pointer indicates a storage position of the to-be-operated data in the storage medium. When data is separately changed, a modification to a learned index is supported, so that an index result obtained through the learned index is more accurate.

In a possible implementation, the operation instruction is an insert instruction, and the executing the operation instruction based on the target key and the target learned index corresponding to the target data group includes: writing the to-be-operated data into a storage medium; and inserting a mapping relationship between the target key and a third pointer into the target learned index, where the third pointer indicates a storage position of the to-be-operated data in the storage medium. When data is separately changed, a modification to a learned index is supported, so that an index result obtained through the learned index is more accurate.

In a possible implementation, the writing the to-be-operated data into the storage medium includes: encoding and compressing the to-be-operated data via an encoder corresponding to the target data group, to obtain compressed data, where the to-be-operated data is structured data, the to-be-operated data includes N data segments obtained through division based on an attribute, the compressed data includes N compressed data segments, the N compressed data segments are obtained by encoding and compressing the N data segments via M sub-encoders of the encoder, and each of the sub-encoders is configured to encode at least one data segment corresponding to one attribute; and writing the compressed data into the storage medium. Data is compressed based on a structure of the data, so that a compression ratio of the data can be improved, and a storage space occupied by the data can be reduced.

In a possible implementation, the operation instruction is a delete instruction, and the executing the operation instruction based on the target key and the target learned index corresponding to the target data group includes: obtaining, through the target learned index based on the target key, a fourth pointer indicating a storage position of target data corresponding to the to-be-operated data; deleting data at the storage position indicated by the fourth pointer; and deleting a mapping relationship between the target key and the fourth pointer from the target learned index. When data is separately changed, a modification to a learned index is supported, so that an index result obtained through the learned index is more accurate.

In a possible implementation, the method further includes: when data distribution in the K data groups satisfies a condition, performing re-clustering in a data set to obtain K updated data groups, and updating a learned index corresponding to each updated data group. When the data distribution changes, the data is re-clustered, and the corresponding learned index is trained to ensure data query efficiency of a data block.

According to a second aspect, this application provides a data processing method. The method is applied to an external computing device, for example, an intelligent chip, a graphics processing unit, an intelligent network interface card, a programmable switch, or the like. The method includes: obtaining a target key, where the target key is obtained by performing product quantization encoding on to-be-operated data or a target residual value in an operation request, the target residual value is a residual value between the to-be-operated data and a centric vector of a target data group, the target data group is a data group to which the to-be-operated data belongs in K data groups, and K is an integer greater than or equal to 1; and obtaining, based on the target key through a target learned index corresponding to the target data group, a pointer corresponding to the target key, where the pointer indicates a storage position of target data corresponding to the to-be-operated data. A part of query operations are offloaded to the external computing device, so that query efficiency can be improved.

In a possible implementation, the obtaining the target key may be: obtaining the target key from a host side, and performing, by a processor on the host side, the product quantization encoding on to-be-operated data, to obtain the target key. In a possible implementation, the obtaining the target key may be: performing, by the external computing device, the product quantization encoding on the to-be-operated data, to obtain the target key.

In a possible implementation, the target learned index is used to output, based on the target key, a pointer corresponding to the to-be-operated data, the target learned index includes a learned index model and a mapping unit, the learned index model is used to output, based on the target key, a target position of the target key in the mapping unit, and a mapping relationship between the target key and the pointer corresponding to the to-be-operated data is stored at the target position.

A target learned index model learns a distribution rule of target keys in the mapping unit, and actual data distribution in a storage medium is decoupled from the target learned index model. In this case, when the data is written into the storage medium, whether the data writing affects a data distribution rule in the storage medium does not need to be considered. The data may be written into the storage medium through appending, so that write performance can be improved. In addition, during data query, a position of the target key in the mapping unit can be quickly hit through the target learned index model, so that a quantity of queries can be reduced. The mapping unit stores a mapping relationship between the target key and the pointer. A storage position of corresponding data can be accurately obtained, thereby improving query accuracy and efficiency.

In a possible implementation, a target learned index model includes a root model, at least two intermediate models, and at least two leaf models, the root model is used to select a target intermediate model from the at least two intermediate models based on the target key, the target intermediate model is used to select a target leaf model from the at least two leaf models, the target leaf model is used to output the target position based on the target key, and the target leaf model is a non-linear function. The non-linear function can better fit key distribution, to predict a position of a key more accurately.

According to a third aspect, this application provides a data processing apparatus. The apparatus includes: a transceiver module, configured to obtain an operation request, where the operation request includes an operation instruction and to-be-operated data; a processing module, configured to perform product quantization encoding on a target residual value or the to-be-operated data to obtain a target key, where the target residual value is a residual value between the to-be-operated data and a centric vector of a target data group, the target data group is a data group to which the to-be-operated data belongs in K data groups, and K is an integer greater than or equal to 1; and the processing module is configured to execute the operation instruction based on the target key and a target learned index corresponding to the target data group.

In a possible implementation, the target learned index is used to output, based on the target key, a pointer corresponding to the to-be-operated data, the target learned index includes a learned index model and a mapping unit, the learned index model is used to output, based on the target key, a target position of the target key in the mapping unit, and a mapping relationship between the target key and the pointer corresponding to the to-be-operated data is stored at the target position.

In a possible implementation, a target learned index model includes a root model, at least two intermediate models, and at least two leaf models, the root model is used to select a target intermediate model from the at least two intermediate models based on the target key, the target intermediate model is used to select a target leaf model from the at least two leaf models, the target leaf model is used to output the target position based on the target key, and the target leaf model is a non-linear function.

In a possible implementation, at least a part of the learned index model is stored in a storage corresponding to an external computing device, and the external computing device is configured to obtain the target intermediate model, the target leaf module, or the target position based on the at least part of the model.

In a possible implementation, the operation instruction is a query instruction, and the query instruction instructs to read target data corresponding to the to-be-operated data; the processing module is configured to obtain a first pointer through the target learned index based on the target key, where the first pointer indicates a storage position of the target data; and the processing module is configured to obtain the target data based on the first pointer, where when the first pointer is associated with one piece of data, the target data is the data associated with the first pointer; or when the first pointer is associated with multiple pieces of data, the target data is data that has a smallest distance from the to-be-operated data in the multiple pieces of data associated with the first pointer.

In a possible implementation, the target data is stored as compressed target data after compression; the processing module is configured to obtain the compressed target data based on the first pointer; and the processing module is configured to decompress the compressed target data via a decoder, to obtain the target data, where the target data is structured data, the target data includes N data segments obtained through division based on an attribute, the compressed target data includes N compressed data segments, the N compressed data segments are obtained by compressing the N data segments via M sub-encoders of an encoder, each of the sub-encoders is configured to encode at least one data segment corresponding to one attribute, the decoder includes M sub-decoders, the M sub-decoders are in one-to-one correspondence with the M sub-encoders, and each of the sub-decoders is configured to decode at least one of the N compressed data segments.

In a possible implementation, the operation instruction is an update instruction; the processing module is configured to write the to-be-operated data into a storage medium; and the processing module is configured to update the target learned index with a mapping relationship between the target key and a second pointer, where the second pointer indicates a storage position of the to-be-operated data in the storage medium.

In a possible implementation, the operation instruction is an insert instruction; the processing module is configured to write the to-be-operated data into a storage medium; and the processing module is configured to insert a mapping relationship between the target key and a third pointer into the target learned index, where the third pointer indicates a storage position of the to-be-operated data in the storage medium.

In a possible implementation, the processing module is specifically configured to encode and compress the to-be-operated data via an encoder corresponding to the target data group, to obtain compressed data, where the to-be-operated data is structured data, the to-be-operated data includes N data segments obtained through division based on an attribute, the compressed data includes N compressed data segments, the N compressed data segments are obtained by encoding and compressing the N data segments via M sub-encoders of the encoder, and each of the sub-encoders is configured to encode at least one data segment corresponding to one attribute; and the processing module is specifically configured to write the compressed data into the storage medium.

In a possible implementation, the operation instruction is a delete instruction; the processing module is configured to obtain, through the target learned index based on the target key, a fourth pointer indicating a storage position of target data corresponding to the to-be-operated data; the processing module is configured to delete data at the storage position indicated by the fourth pointer; and the processing module is configured to delete a mapping relationship between the target key and the fourth pointer from the target learned index.

In a possible implementation, the apparatus further includes: when data distribution in the K data groups satisfies a condition, performing re-clustering in a data set to obtain K updated data groups, and updating a learned index corresponding to each updated data group.

According to a fourth aspect, this application provides a data processing apparatus. The apparatus includes: a processing module, configured to obtain a target key, where the target key is obtained by performing product quantization encoding on to-be-operated data or a target residual value in an operation request, the target residual value is a residual value between the to-be-operated data and a centric vector of a target data group, the target data group is a data group to which the to-be-operated data belongs in K data groups, and K is an integer greater than or equal to 1; and the processing module is configured to obtain, based on the target key through a target learned index corresponding to the target data group, a pointer corresponding to the target key, where the pointer indicates a storage position of target data corresponding to the to-be-operated data.

According to a fifth aspect, this application provides a computing device. The computing device includes at least one processor and at least one storage. The at least one storage stores computer-readable instructions. The at least one processor executes the computer-readable instructions, to cause the computing device to perform the method according to any one of the first aspect or the possible implementations of the first aspect, or the method according to any one of the second aspect or the possible implementations of the second aspect.

According to a sixth aspect, this application provides a computer-readable storage medium. The computer-readable storage medium includes computer-readable instructions. The computer-readable instructions are used to implement the method according to any one of the first aspect or the possible implementations of the first aspect, or the method according to any one of the second aspect or the possible implementations of the second aspect.

According to a seventh aspect, this application provides a computer program product, including computer-readable instructions. The computer-readable instructions are used to implement the method according to any one of the first aspect or the possible implementations of the first aspect, or the method according to any one of the second aspect or the possible implementations of the second aspect.

### BRIEF DESCRIPTION OF DRAWINGS

FIG. 1 is a structured data storage system combined with a foundation model;
FIG. 2a and FIG. 2b are diagrams of a software architecture of a data processing system according to this application;
FIG. 3 is a diagram of performing query by using a data processing system according to this application;
FIG. 4a is a diagram of a structure of a learned index according to this application;
FIG. 4b is a diagram of a structure of a learned index model according to this application;
FIG. 5a is a diagram of encoding data by a structure-aware encoder according to this application;
FIG. 5b is a diagram of decoding compressed data by a structure-aware decoder according to this application;
FIG. 6 is a diagram of a hardware architecture of a data processing system according to this application;
FIG. 7 is a schematic flowchart of a data processing method according to this application;
FIG. 8a is a diagram of an index when an operation request is a query request;
FIG. 8b is a diagram of an index when an operation request is an update request;
FIG. 8c is a diagram of an index when an operation request is an insert request;
FIG. 9 is a diagram of retraining an index structure;
FIG. 10 shows a comparison between a solution provided in this application and an existing solution in terms of query test results of 1 million vectors;
FIG. 11 shows a comparison between a solution provided in this application and an existing solution in terms of query test results of 1 million vectors based on different databases;
FIG. 12 is a diagram of a structure of a data processing apparatus according to this application;
FIG. 13 is a diagram of a structure of another data processing apparatus according to this application; and
FIG. 14 is a diagram of a structure of a computing device according to this application.

### DESCRIPTION OF EMBODIMENTS

The following describes embodiments of this application with reference to accompanying drawings. It is clear that the described embodiments are merely a part rather than all of embodiments of this application. A person of ordinary skill in the art may know that with development of technologies and emergence of new scenarios, technical solutions provided in embodiments of this application are also applicable to similar technical problems.

In the specification, claims, and accompanying drawings of this application, the terms "first", "second", and so on are intended to distinguish between similar objects but do not necessarily indicate a specific order or sequence. In descriptions of this application, unless otherwise specified, "multiple" means two or more than two.

The special term "example" herein means "used as an example, embodiment or illustration". Any embodiment described as "an example" is not necessarily explained as being superior or better than other embodiments.

In embodiments of this application, unless otherwise stated or there is a logic conflict, terms and/or descriptions between different embodiments are consistent and may be mutually referenced, and technical features in the different embodiments may be combined based on an internal logical relationship thereof, to form a new embodiment.

Nouns used in this application are explained below.

Structured data is organized data whose length and format are defined. The structured data is a type of data that can be stored in a table or a relational database. This structure makes search for specific data more efficient, and helps explore data potential and realize application value of data.

A learned index (learned index) is an index structure that focuses on a data distribution rule. The learned index may be considered as a machine learning model, and may learn the data distribution rule through training to obtain an adaptive model. A to-be-queried key is input into the learned index, and the learned index may output a position corresponding to the key.

Product quantization (product quantization, PQ) is a vector quantization technology that decomposes a high-dimensional vector into low-dimensional subvectors and quantizes each subvector. The PQ has been used as a method to provide faster approximate nearest neighbor search. The PQ is also used in fields such as information retrieval and embedded matrix compression in natural language processing (natural language processing, NLP). The product quantization specifically includes three phases: codebook training, quantization, and query. In the codebook training phase, for n samples (each sample is a D-dimensional vector) in a data set, the sample is divided into m subspaces. To be specific, each sample is divided into m D/m-dimensional subvectors, and each subspace includes n subvectors. In each subspace, the n subvectors are clustered by using a clustering algorithm, for example, a K-Means algorithm (K-Means), to obtain K clusters. A clustering center (centroid) of each cluster serves as a representative of the cluster, and a center of each cluster is represented by a cluster number (cluster ID). In this way, a codebook corresponding to each subspace can be obtained. In the quantization phase, each sample in the data set is divided into m D/m-dimensional subvectors. Then, each subvector is encoded by using a cluster number of a nearest clustering center in a subspace to which the subvector belongs, to obtain an m-dimensional short code vector. In the query phase, for a to-be-queried vector, top-K nearest neighbor samples may be found in the data set through symmetric distance calculation or asymmetric distance calculation. A symmetric distance calculation means that distances between a short code vector obtained by performing product quantization encoding on the to-be-queried vector and short code vectors corresponding to all samples in the data set are calculated, and the top-K nearest samples are selected based on the distances. The asymmetric distance calculation means that the to-be-queried vector is divided in a same manner to obtain m D/m-dimensional subvectors, and distances between each subvector and vectors of K clustering centers in a subspace to which the subvector belongs are calculated. In this case, a total of m*K distances may be obtained, and may be referred to as a distance table for short. The samples in the data set are traversed, a sum of distances between the to-be-queried vector and each sample is calculated based on the distance table, and the top-K nearest samples are selected based on sums of distances.

Inverted product quantization is as follows: Samples in a data set are classified into K clusters at a coarse granularity by using a clustering algorithm, and each cluster has a clustering center. For each sample in the data set, subtraction is performed between the sample and a nearest clustering center to obtain a residual vector. Then, product quantization is performed on the residual vector to obtain a short code vector. A product quantization process of the residual vector is similar to the foregoing product quantization process, and details are not described herein again. During query, a residual vector between a to-be-queried vector and each clustering center is calculated, a cluster corresponding to a smallest residual vector is determined as a cluster to which the to-be-queried vector belongs, and the top-K nearest samples are found, by using a symmetric distance calculation method or an asymmetric distance calculation method, in the cluster to which the to-be-queried vector belongs. Different from the product quantization, in the inverted product quantization, nearest samples are found, based on a short code corresponding to the residual vector, in the cluster to which the to-be-queried vector belongs. In this way, errors can be reduced, a query range can be narrowed, and query efficiency can be improved.

Lossless compression is compression performed by using statistical redundancy of data, and original data can be completely restored without any distortion, but a compression ratio is theoretically limited by the statistical redundancy of the data.

A main storage object of a structured data database is structured data, and each piece of structured data represents a data object. A large quantity of data objects are usually stored in the structured data database. A dimension of the structured data is usually determined by a user representation or a data object representation. Two major problems need to be resolved in the structured data database: The first one is efficient query, and the second one is efficient analysis and storage.

When the structured data database is established, all data objects need to be analyzed, and an efficient index system needs to be constructed, so that nearer structured data can quickly find each other. When a user specifies a piece of queried structured data, the structured data database needs to find, based on the index system constructed by the structured data database, k pieces of structured data that are most related to the queried structured data, to find corresponding data objects.

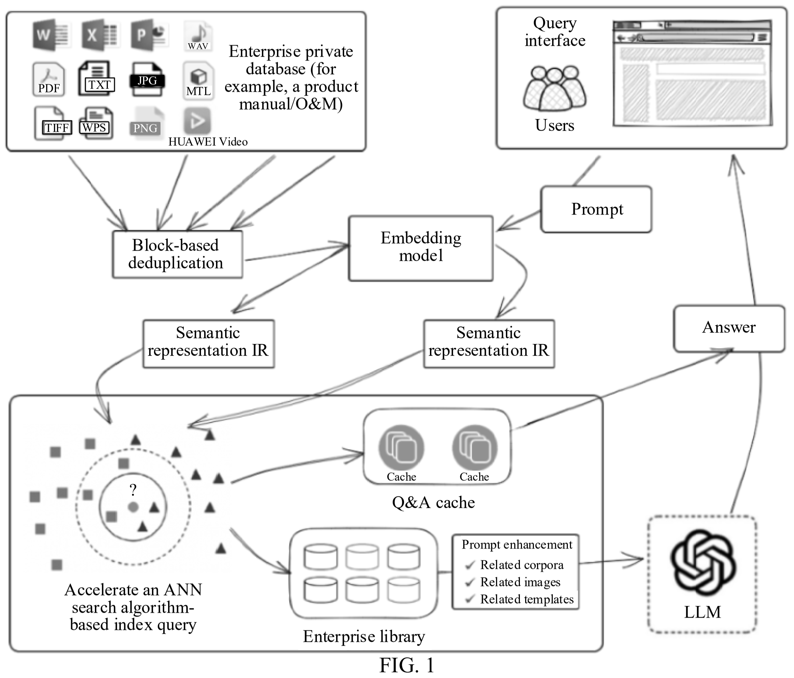

With the advent of the foundation model era, there is an explosive demand for structured data databases. As shown in FIG. 1, a structured data database plays two important roles: 1. Cache: The structured data database can cache popular questions and answers returned by a foundation model. In this way, when another user searches for a similar question, the structured data database can quickly respond, avoiding wastes of computing power and time upon answering the question again by the foundation model. 2. User private data storage: Training the foundation model based on the user private data storage faces problems such as low timeliness and huge resource consumption. Nevertheless, based on the structured data database, a data object required by a user can be quickly matched, and processing and optimization are performed based on the foundation model. This reduces training overheads and improves efficiency of answering domain questions using the foundation model.

With continuous growth of an amount of user data, it is difficult for an existing structured data database technology to maintain an amount of data of a sufficient scale. In addition to a data object, a structured data representation of the data object becomes a new type of metadata storage, and brings great storage overheads and computing pressure to a storage system.

For efficient query, the inverted product quantization is used for high-dimensional vector similarity search. This can improve query performance to some extent. However, in large-scale structured data storage, index space occupation is still excessively large, and query overheads are still high. For example, in a scenario of querying for approximate top-K approximate images, in the inverted product quantization, one query takes about 100 µs.

For efficient storage and analysis, conventional compression algorithms include an entropy coding technology, a dictionary-based compression technology, and the like. Through the entropy coding technology, a given segment of data content may be compressed based on arithmetic coding/range encoding. The dictionary-based compression technology, for example, Run-Length Encoding, LZ77/LZW/LZAM, and zstd, has poorer compression performance than the entropy encoding technology, and usually has an outstanding compression effect on text. In the conventional compression algorithms, random decompression of one piece of data usually requires decompression of data blocks that participate in compression. This results in read amplification. In addition, in the conventional algorithms, approximate data cannot be distinguished for compression, and a compression ratio needs to be further improved.

To resolve the foregoing technical problems, this application provides the following solutions.

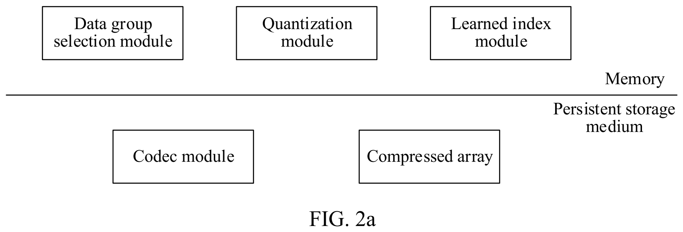

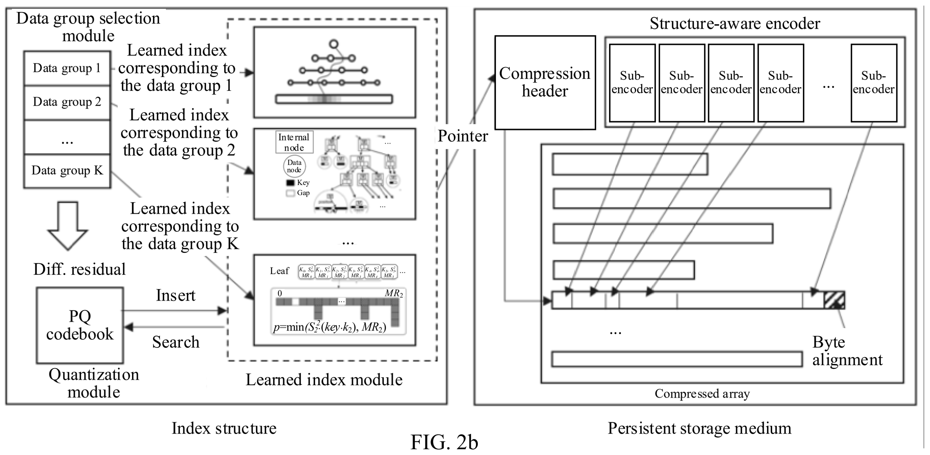

FIG. 2a and FIG. 2b are diagrams of an architecture of a data processing system according to this application. The data processing system includes a data group selection module, a quantization module, a learned index module, and the like. The data group selection module is configured to determine a data group to which data belongs. The quantization module is configured to perform quantization encoding on the data to obtain a short code vector, to compress a data length. The learned index module uses the short code vector as a key to output a value (pointer) corresponding to the key.

A lifecycle of the data processing system includes a construction phase, a use phase, and a retraining phase. In the construction phase, parameters in the data group selection module, the quantization module, the learned index module, and the like are trained. In the use phase, an operation instruction of a user is executed based on a trained data processing system. In the retraining phase, the parameters in the data group selection module, the quantization module, the learned index module, and the like of the data processing system are retrained when a data distribution change of data managed by the data processing system satisfies a condition.

Specifically, in the construction phase, multiple pieces of data in a data set are clustered into K data groups (or referred to as clusters) by using a clustering algorithm (for example, K-Means), and a vector of a clustering center (namely, a cluster centroid, referred to as a centric vector for short below) of each data group is obtained. Data in multiple data groups does not overlap. Approximate data in the data set is clustered into a same data group. K is an integer greater than or equal to 1. After the data groups are obtained through division, a PQ codebook in the quantization module is trained. In a possible implementation, PQ codebooks are trained by using original data in the data groups. In this case, a corresponding PQ codebook may be trained for each data group. In another possible implementation, a PQ codebook is trained by using a residual vector between data in a data group and a centric vector of the data group. In this case, all data groups may share one PQ codebook. In another possible implementation, a PQ codebook may be trained by using original data in a part of the data groups, and a PQ codebook may be trained by using residual vectors for a part of the data groups. In this case, training is performed for the data group whose original data is used to train the PQ codebook, to obtain a corresponding PQ codebook, that is, one data group corresponds to one PQ codebook; and one PQ codebook may be trained jointly for the data groups whose residual vectors are used to train the PQ codebook, that is, the data groups may share one PQ codebook.

To improve index precision of the learned index module, in this embodiment, each data group corresponds to one learned index. For a learned index corresponding to a data group, the learned index is trained by using a short code vector corresponding to data in the data group as a key and using a pointer (pointer) indicating a storage position of the data as a value, so that the learned index can learn a mapping relationship between the key and the pointer that correspond to the data in the data group, and the learned index can accurately output the storage position of the corresponding data based on the key.

After construction is completed, a centric vector (a parameter in the data group selection module) of each data group, a PQ codebook (a parameter in the quantization module), and a learned index (a parameter in the learned index module) corresponding to each data group may be obtained. In this way, a constructed data processing system can process an operation request of a user. The operation request includes, for example, a query request, an update request, an insert request, and a delete request. The operation request includes to-be-operated data. The operation request may be a single operation or batch operations.

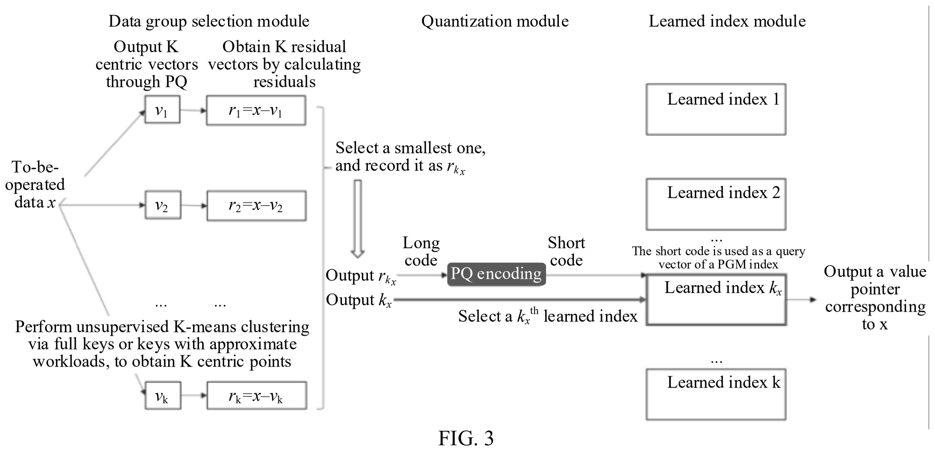

In the use phase, as shown in FIG. 3, the data group selection module is configured to determine a target data group to which the to-be-operated data belongs. The data group to which the to-be-operated data belongs may be determined in multiple manners. For example, the data group selection module calculates residuals between the to-be-operated data and centric vectors of the K data groups, and selects a data group with a smallest residual value as the target data group. For another example, the data group selection module calculates distances between the to-be-operated data and centric vectors of the K data groups, and selects a data group with a smallest distance as the target data group.

The quantization module is configured to: quantize the to-be-operated data into a short code vector, or quantize a target residual vector between the to-be-operated data and the target data group into a short code vector. The short code vector is a target key to be input into the learned index module. When data quantized by the quantization module is the to-be-operated data, the quantization module selects a PQ codebook corresponding to the target data group to quantize the to-be-operated data, to obtain the short code vector corresponding to the to-be-operated data. When data quantized by the quantization module is the target residual vector, the quantization module quantizes the target residual vector by using the PQ codebook obtained through residual vector training, to obtain the short code vector corresponding to the to-be-operated data.

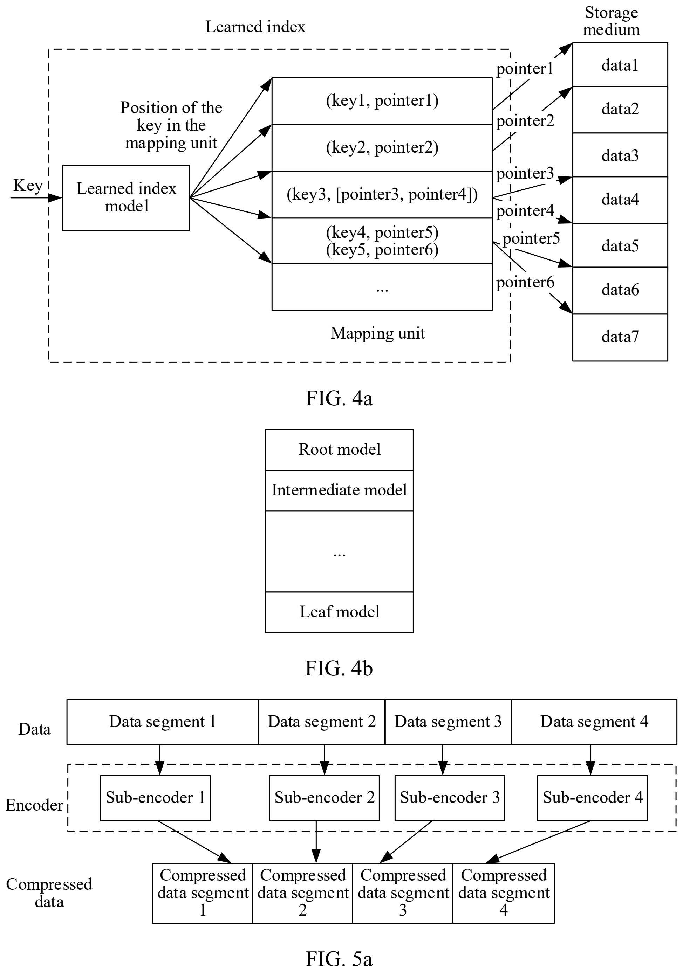

The learned index module includes learned indexes corresponding to the multiple data groups. As shown in FIG. 4a, the learned index includes a learned index model and a mapping unit. It may be understood that FIG. 4a is merely an example, and should not be construed as a limitation on this application. The learned index model learns a distribution rule of keys (short code vectors) in the mapping unit through training, and can accurately predict a position of a key in the mapping unit. The mapping unit stores multiple key-value (or referred to as key-pointer) pairs, and the value is a pointer indicating a storage position of data corresponding to the key. For any data in the data groups, a corresponding pointer exists in the mapping unit to indicate a storage position of the data. In this way, precise addressing can be performed on the data in the data groups based on the key-pointer pairs in the mapping unit. A process of querying a pointer of data corresponding to a key based on the learned index is as follows: The learned index model outputs a position of the key in the mapping unit based on the key. A pointer having a mapping relationship with the key is stored at the position. The mapping unit obtains the pointer of the position at the position output by the learned index model, and outputs the pointer. In this embodiment, a pointer may be a storage position of data. The pointer may alternatively be an identifier of the data, and the identifier can be used to obtain a storage position of the data.

In a possible implementation, as shown in FIG. 4b, a learned index model is of a hierarchical structure, and includes a root model, at least two intermediate models, and at least two leaf models. The root model is used to select one intermediate model from the at least two intermediate models based on a key. The intermediate model selected by the root model is used to select one leaf model from the at least two leaf models based on a key. In a possible implementation, learned indexes are stored in a form of a linear table, the root model may output an offset (offset) of the selected intermediate model, and the intermediate model may output an offset of the selected leaf model, to obtain and run a corresponding model based on an offset. In another implementation, the root model may output a model identifier of the selected intermediate model, and the intermediate model may output a model identifier of the selected leaf model. A storage position of a model is determined based on a mapping relationship between a model identifier and a storage position of the model corresponding to the model identifier in a memory, to obtain and run the model corresponding to the model identifier. The leaf model selected by the intermediate model is used to output a position of the key in a mapping unit based on the key. Optionally, the leaf model may be a non-linear function such as Relu, sigmoid, and Tanh. The non-linear function can better fit key distribution, to predict a position of a key more accurately. Certainly, in another possible implementation, the learned index model may alternatively be a fitting tree (FITing-TREE) index, an adaptive learned index (Adaptive Learned index, ALEX), a piecewise geometric model index (Piecewise Geometric Model Index, PGM), an updatable learned index with precise positions (Updatable Learned Index with Precise Positions, LIPP), or the like. In this embodiment, for K learned index models in K learned indexes, a same learned index model may be used, or different learned index models may be used. This is not limited herein.

Optionally, the learned index model is a lightweight model. For example, the learned index model includes no complex neural network model, so that the learned index model occupies a small storage space and can be cached in the memory. In a possible implementation, the learned index model may be completely cached in a memory on a host side. In another possible implementation, the learned index model may be completely cached in a memory on a device side. In still another possible implementation, the learned index model may be partially cached in a memory on a host side and partially cached in a memory on a device side. For example, the root model and intermediate models are cached in the memory on the device side, and the leaf models are cached in the memory on the host side. Alternatively, the root model and the leaf models are cached in the memory on the host side, and the intermediate models are cached in the memory on the device side; and so on. Examples are not enumerated herein.

The mapping unit includes multiple mapping subunits (which may also be referred to as buckets), and each mapping subunit stores at least one key-pointer pair. The position that is of the key in the mapping unit and that is output by the learned index model based on the key is a position of a mapping subunit that stores a key-pointer pair corresponding to the key. One mapping subunit may store only one key-pointer pair, that is, the mapping subunit stores only a mapping relationship between one key and one pointer. One mapping subunit may alternatively store multiple key-pointer pairs. In a possible implementation, the multiple key-pointer pairs stored in the mapping subunit may be mapping relationships between a same key and multiple pointers. This is because a conflict may occur when high-dimensional data is quantized and compressed into a low-dimensional short code vector. To be specific, pieces of different but approximate data are quantized and compressed to obtain a same short code vector. As a result, there are mapping relationships between one short code vector and pointers of multiple pieces of data. Alternatively, the multiple key-pointer pairs stored in the mapping subunit are mapping relationships between multiple keys and multiple pointers, and one pointer has a mapping relationship with only one key. One mapping subunit stores multiple key-pointer pairs. In this case, the conflict is brought about by the learned index model, and different short code vectors are mapped to a same mapping subunit. Such conflicts may be reduced by optimizing the learned index. For example, the learned index model may be trained through insertion. To be specific, key-pointer pairs are inserted into the mapping unit, and a key-pointer pair corresponding to only one key is inserted into one mapping subunit, to ensure that keys are distributed in an orderly manner in the mapping unit. Then, the learned index model is trained based on keys and positions of the keys in the mapping unit. The learned index model is trained and optimized in a bottom-up training manner, so that during query, the learned index model can accurately predict a position of a key in the mapping unit, and obtain a corresponding pointer.

One pointer may indicate a storage position of only one piece of data. One pointer may alternatively indicate a storage position of multiple pieces of data. For example, pieces of different but approximate data are quantized and compressed to obtain a same short code vector. In a possible implementation, each piece of data in the data may correspond to a pointer indicating a storage position of the data, and the mapping subunit stores mapping relationships between one key and multiple pointers. In another possible implementation, the pieces of data may be stored continuously and a storage position of the pieces of data is indicated by one pointer. In this case, the mapping subunit stores a mapping relationship between one key and one pointer.

As shown in FIG. 4a, the following summarizes possible relationships between a mapping subunit, a key, a pointer, and data.
1. One mapping subunit stores one key-pointer pair, and one pointer indicates a storage position of one piece of data. In this case, the learned index module outputs one pointer, and the pointer uniquely indicates a storage position of one piece of data. For example, a mapping subunit B1 in FIG. 4a stores one key-pointer mapping relationship (key1, pointer1), and the pointer pointer1 indicates only a storage position of data data1.
2. One mapping subunit stores one key-pointer pair, and one pointer indicates a storage position of multiple pieces of data. To be specific, the multiple pieces of data correspond to a same short code vector, these pieces of data are continuously stored, and the storage position of these pieces of data is indicated by the pointer. In this case, the learned index module outputs one pointer, and the pointer indicates a storage position of multiple pieces of data. For example, a mapping subunit B2 in FIG. 4a stores one key-pointer mapping relationship (key2, pointer2), and the pointer pointer1 indicates a storage position of data data2 and data3.
3. One mapping subunit stores multiple key-pointer pairs, there is a same key in the multiple key-pointer pairs, and different pointers indicate storage positions of different data. In this case, the learned index module outputs multiple pointers, and each pointer indicates a storage position of one piece of data. For example, a mapping subunit B3 in FIG. 4a stores two key-pointer mapping relationships (key3, pointer3) and (key3, pointer4), the pointer pointer3 indicates a storage position of data data4, and the pointer pointer4 indicates a storage position of data5.
4. One mapping subunit stores multiple key-pointer pairs, and keys in the multiple key-pointer pairs include different keys. For example, a mapping subunit B4 in FIG. 4a stores two key-pointer mapping relationships (key4, pointer5) and (key5, pointer6), the pointer pointer5 indicates a storage position of data data6, and the pointer pointer6 indicates a storage position of data7. In this case, the learned index module may match an input key with the multiple key-pointer pairs in the mapping subunit, and output only a pointer that has a mapping relationship with the input key. When the key input to the learned index module has a mapping relationship with only one pointer and the pointer indicates a storage position of only one piece of data, the learned index module outputs one pointer, and the pointer uniquely indicates a storage position of one piece of data. When the key input to the learned index module has a mapping relationship with only one pointer and the pointer indicates a storage position of multiple pieces of data, the learned index module outputs one pointer, and the pointer indicates the storage position of the multiple pieces of data. When the key input to the learned index module has mapping relationships with multiple pointers and one pointer indicates a storage position of only one piece of data, the learned index module outputs multiple pointers, and each pointer indicates a storage position of one piece of data.

An example in which one pointer indicates a storage position of one piece of data is used below for description.

When the operation instruction is a query instruction, an update instruction, or a delete instruction, a storage position of target data corresponding to the to-be-operated data needs to be queried through the learned index module based on the target key corresponding to the to-be-operated data. Specifically, a target learned index corresponding to the target data group can be determined in multiple learned indexes based on the target data group to which the to-be-operated data belongs and that is determined by the data group selection module. A target learned index module can output a pointer, corresponding to the target data, based on the target key corresponding to the to-be-operated data. The target data may be the to-be-operated data, data including the to-be-operated data, data associated with the to-be-operated data, or data approximate to the to-be-operated data. When the target key corresponds to multiple pieces of data (the target key has mapping relationships with multiple pointers), the multiple pieces of data may be read based on the multiple pointers, and these pieces of data are candidate data. Then, a distance between each piece of candidate data and the to-be-operated data is calculated, candidate data nearest to the to-be-operated data is determined as the target data, and a pointer corresponding to the candidate data nearest to the to-be-operated data is determined as a target pointer, to perform a corresponding operation on the target data and/or the target pointer.

When the operation instruction is an update instruction, an insert instruction, or a delete instruction, a mapping relationship between a key and a pointer may change, or a new mapping relationship between a key and a pointer is generated. In this case, a mapping unit needs to be updated with a new or changed mapping relationship between a key and a pointer.

When the operation instruction is the insert instruction or the delete instruction, a corresponding key is inserted into a mapping unit or deleted from the mapping unit. This may cause a change in key distribution in the mapping unit. When key distribution in an area of the mapping unit changes or accumulates changes, a leaf model corresponding to the area may be retrained, that is, a learned index model may be partially adjusted, so that prediction accuracy of the learned index model can be ensured, and conflicts can be reduced. In addition, a training speed can be improved.

A short code vector is obtained by performing PQ encoding on data. A dimension of the data is reduced, a storage space occupied by a mapping unit can be reduced, costs of training and prediction of a learned index can be reduced, and prediction performance can be improved. In addition, an order can be preserved, and orderly and even distribution of keys can be ensured, so that prediction precision of a learned index model is improved. Through the learned index model, a position of a key in the mapping unit can be quickly and accurately located, and the position of the key in the mapping unit does not need to be determined in a manner such as traversal or binary search. The mapping unit stores a mapping relationship between a key and a pointer corresponding to data, and the pointer indicates a precise storage position of the data. A pointer having a mapping relationship with a key may be obtained based on a position of the key, and the pointer directly or indirectly indicates a storage position of data, so that a precise storage position of the data can be obtained.

In the retraining phase, due to operations such as update, insertion, and deletion, data distribution in the data groups may be greatly different, affecting query performance and accuracy of the learned index module. Therefore, when a data distribution difference between the data groups satisfies a condition, the data set may be retrained. That the data distribution difference between the data groups satisfies the condition may mean that a difference between quantities of elements in different data groups exceeds a threshold, or a mean square error of the quantities of elements in the different data groups exceeds a threshold. Retraining is to re-cluster the multiple pieces of data in the data set into K data groups, obtain a vector of a clustering center of each data group, and retrain a PQ codebook and a learned index corresponding to each data group. A retraining process is similar to the construction process, and details are not described herein again.

Optionally, to improve utilization of a storage medium, when data is written into the storage medium for persistent storage, the data may be compressed first to obtain compressed data, and the compressed data is written into the storage medium. Correspondingly, when data is read from the storage medium, the read compressed data needs to be decompressed first to obtain uncompressed data. The storage medium is, for example, a persistent storage device like a solid-state drive or a hard disk drive.

Therefore, the data processing system may further include a codec module and a compressed array. The codec module includes encoder and decoder. The encoder is configured to encode and compress data to be written into the storage medium, to obtain compressed data. The compressed data is stored in the compressed array of the storage medium. The decoder is configured to decode the compressed data read from the storage medium and restore the compressed data to data in an uncompressed state.

In the system construction phase, the codec module is further trained. All data in the data set is, for example, structured data, structures of all the data are consistent, and each piece of data includes multiple data segments with different attributes. The encoder is a structure-aware encoder. To be specific, the encoder can be aware of data segments with different attributes in data, and train one corresponding sub-encoder and one corresponding sub-decoder for a data segment with each attribute. The encoder can be aware of a structure of the data based on a hint (hint), so that the data can be divided into data segments with different attributes. The encoder may alternatively be aware of a structure of the data by analyzing a data rule, so that the data can be divided into data segments with different attributes. For example, if the data includes, for example, a gender field and an age field, a data segment corresponding to the gender field is with an attribute, and a data segment corresponding to the age field is with an attribute. Assuming that the data is a 100-dimensional vector, the age field corresponds to dimensions 0 to 3, and the gender field corresponds to dimensions 4 and 5. In this case, one data segment corresponding to the dimensions 0 to 3 may be obtained through division, and one data segment corresponding to the dimensions 4 and 5 may be obtained through division.

Optionally, to improve a compression ratio, one encoder and one decoder may be trained for each data group. Certainly, the K data groups may alternatively share one encoder and one decoder. This is not limited herein. For example, one encoder is trained for one data group. When the encoder is trained, data segments with a same attribute in the data group are used to train a corresponding sub-encoder. Data in the data segments with the same attribute has a specific rule. For example, some specific characters appear more frequently, and character types are concentrated, so that a trained sub-encoder has a higher compression ratio for the data segments with the attribute. During retraining, the codec module may not be trained, that is, the codec module remains unchanged, to avoid effect, on normal use of a database, caused by reading the compressed data from the storage medium and performing processing, decompressing, and re-compressing on the data. The encoder may be a structure-aware Hoffman (Huffman) coder or the like. Certainly, the encoder may alternatively be another structure-aware lossless encoder, for example, an entropy encoder like structure-aware Shannon (Shannon) coding or structure-aware arithmetic coding (arithmetic coding).

When data is written into the storage medium, a trained encoder is used to compress and encode the data. It is assumed that the data includes N data segments divided based on attributes, and the encoder includes M sub-encoders. Each sub-encoder is configured to encode a data segment corresponding to one of the attributes, and each sub-encoder is configured to encode at least one of the N data segments. The sub-encoder is obtained through training based on the data segment that is in a data group to which the data belongs and that corresponds to the attribute. N is greater than or equal to M, and both M and N are integers greater than 1. Because the data before the compression is structured data, lengths of different data segments of the data are fixed. Therefore, the data may be split into multiple data segments based on the lengths corresponding to the data segments, and the data segments corresponding to the attributes are encoded and compressed in parallel through the sub-encoders, to improve compression efficiency. Certainly, the data may alternatively be sequentially encoded through the sub-encoders in a serial manner. This is not limited herein.

For example, as shown in FIG. 5a, data includes four data segments corresponding to four attributes, namely, a data segment 1 corresponding to an attribute 1, a data segment 2 corresponding to an attribute 2, a data segment 3 corresponding to an attribute 3, and a data segment 4 corresponding to an attribute 4. An encoder includes four sub-encoders: a sub-encoder 1, a sub-encoder 2, a sub-encoder 3, and a sub-encoder 4. The sub-encoder 1 is obtained through training based on data segments, corresponding to the attribute 1, of multiple pieces of data in a data group, the sub-encoder 2 is obtained through training based on data segments, corresponding to the attribute 2, of multiple pieces of data in the data group, the sub-encoder 3 is obtained through training based on data segments, corresponding to the attribute 3, of multiple pieces of data in the data group, and the sub-encoder 4 is obtained through training based on data segments, corresponding to the attribute 4, of multiple pieces of data in the data group. The sub-encoder 1 encodes the data segment 1 to obtain a compressed data segment 1, the sub-encoder 2 encodes the data segment 2 to obtain a compressed data segment 2, the sub-encoder 3 encodes the data segment 3 to obtain a compressed data segment 3, and the sub-encoder 4 encodes the data segment 4 to obtain a compressed data segment 4. The four sub-encoders may encode the corresponding data segments at the same time, and splice the compressed data segment 1, the compressed data segment 2, the compressed data segment 3, and the compressed data segment 4 to obtain complete compressed data. The four encoders may alternatively sequentially encode the corresponding data segments. For example, first, the sub-encoder 1 encodes the data segment 1, then the sub-encoder 2 encodes the data segment 2, then the sub-encoder 3 encodes the data segment 3, and finally, the data segment 4 encodes the data segment 4.

When data stored in the storage medium needs to be read, the decoder needs to decompress the data in the storage medium. It is assumed that the compressed data includes N compressed data segments. The decoder includes M sub-decoders, and the M sub-decoders are in one-to-one correspondence with the M encoders. Each sub-decoder is configured to decode a compressed data segment corresponding to one attribute, and each sub-decoder is configured to decode at least one of the N compressed data segments. Because a length of a data segment in the data is not fixed after compression, the M sub-decoders may serially decompress the compressed data, and each sub-decoder identifies an ending position of a compressed data segment corresponding to the sub-decoder in the compressed data.

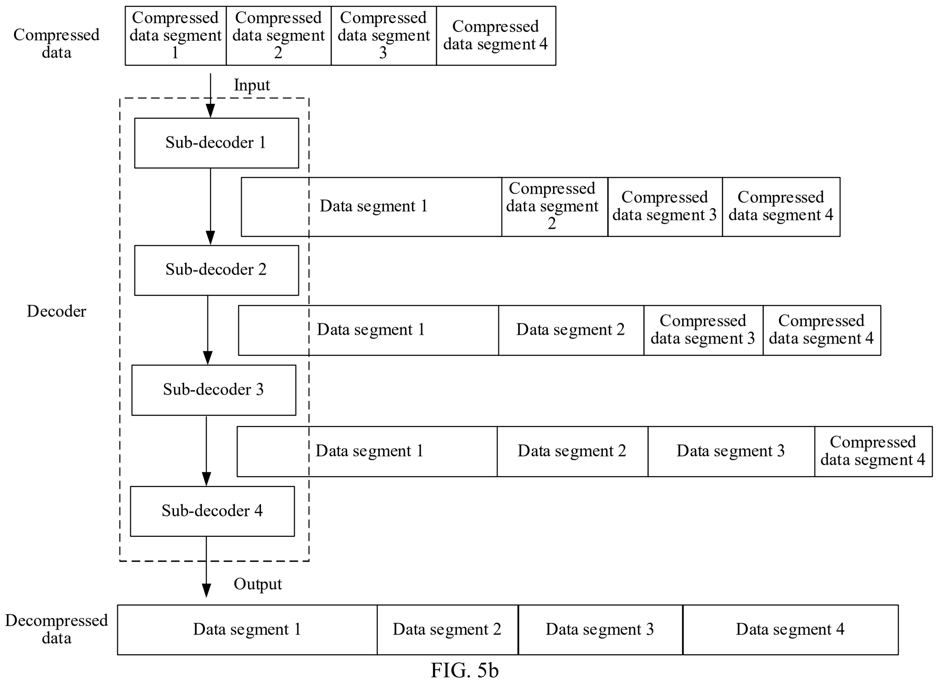

For example, as shown in FIG. 5b, the compressed data includes four compressed data segments corresponding to four attributes, namely, a compressed data segment 1 corresponding to an attribute 1, a compressed data segment 2 corresponding to an attribute 2, a compressed data segment 3 corresponding to an attribute 3, and a compressed data segment 4 corresponding to an attribute 4. The decoder includes four sub-decoders: a sub-decoder 1, a sub-decoder 2, a sub-decoder 3, and a sub-decoder 4. The sub-decoder 1 corresponds to the sub-encoder 1, the sub-decoder 2 corresponds to the sub-encoder 2, the sub-decoder 3 corresponds to the sub-encoder 3, and the sub-decoder 4 corresponds to the sub-encoder 4. After the compressed data is input to the decoder, the sub-decoder 1 first decompresses the compressed data from a beginning until identifying an end of the compressed data segment 1, then the sub-decoder 2 starts decompression from a position at which the previous decompression stops in the compressed data, until identifying an end of the compressed data segment 2, then the sub-decoder 3 starts decompression from a position at which the previous decompression stops in the compressed data, until identifying an end of the compressed data segment 3, and finally the sub-decoder 4 starts decompression from a position at which the previous decompression stops in the compressed data, until completing decompression of the compressed data segment 4, to obtain complete decompressed data.

Pieces of compressed data belonging to a same data group may be continuously stored in the storage medium. Because the length of the compressed data is not fixed, in this embodiment, start position information of the compressed data in the storage medium is recorded by using a compression header. Because multiple pieces of compressed data are stored continuously, the compression header records a data block and a bit, in the data block, at which a start position of the compressed data is located. Optionally, the compression header may be compressed and stored in the storage medium, to reduce a storage space occupied by the compression header. Certainly, the compression header may alternatively be directly stored in the storage medium without being compressed. Optionally, the compression header may be arranged before the pieces of compressed data of the same data group that are continuously stored, and is used as a header of the data group.

When the target data needs to be read from the storage medium, a start position of compressed target data corresponding to the target data may be determined based on the pointer and the compression header. In a possible implementation, the pointer may be an identifier (ID) of the target data. An ID is allocated to each piece of data in the data group. ID numbers are consistent with storage rankings of compressed data. Start position information of each piece of data in a data header may be stored in a form of an array, and the start position information of each piece of data has a same length in the compression header. A position of the start position information of the compressed target data stored in the compression header can be obtained through calculation based on the pointer and the length of the start position information, so that the start position information of the compressed target data can be obtained from the position, and the compressed target data can be read based on the start position information. In another possible implementation, the pointer may be a position of the start position information of the compressed target data in the compression header, so that the start position information of the compressed target data may be obtained from the compression header based on the pointer, and the compressed target data may be read based on the start position information.

When the compression header is stored in the storage medium in a compressed form, the compression header may be first read and decompressed. In a possible implementation, the entire compression header may be decompressed and cached in the memory. In another possible implementation, the compression header may be decompressed as required. To be specific, the decompression can be ended when the start position information of the compressed target data is obtained. A decompressed part of the compression header may be cached in the memory. Subsequently, when start position information of queried data is cached in the memory, the compression header may not need to be decompressed again, and the start position information of the queried data may be directly obtained from the memory, to improve query efficiency. When the start position information of the queried data is not decompressed into the memory, decompression may start from a position at which the previous decompression stops in the compression header, until the start position information of the queried data is obtained, so that the compression header does not need to be decompressed from a beginning, to improve data query efficiency.

In this embodiment, when data is stored in the storage medium in a form of compressed data, start position information of each piece of compressed data is recorded in the compression header, so that any compressed data can be randomly read, and all other irrelevant data does not need to be read and decompressed together. This can reduce write amplification and improve read performance of the compressed data. In addition, in this embodiment, data is segmented and compressed based on a data structure. This can improve a compression ratio of the data, further reduce a storage space occupied for data storage, and improve utilization of the storage medium.

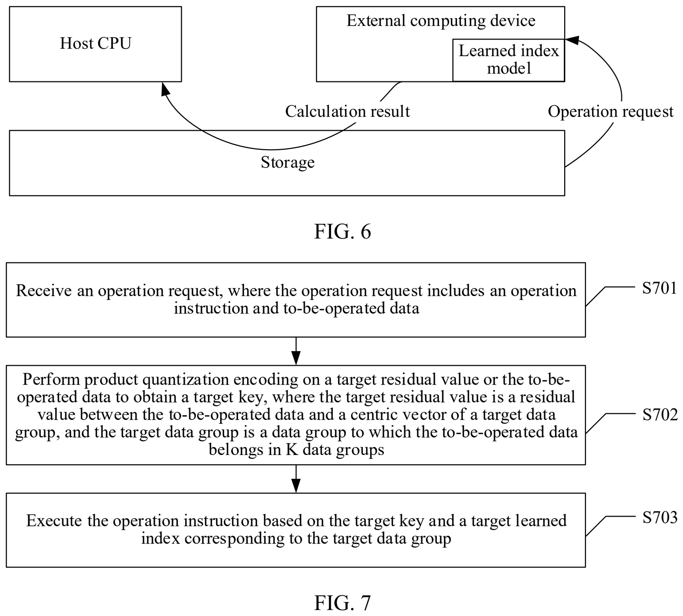

FIG. 6 is a diagram of hardware system architecture according to this application. The hardware system architecture in this embodiment. The hardware system includes a host central processing unit (Central Processing Unit, CPU), an external computing device, and a storage. The host CPU and the external computing device are separately connected to the storage. The storage is configured to store a query request. The external computing device may obtain the query request from the storage and perform corresponding calculation to obtain a calculation result (for example, a pointer indicating a data storage position, or information indicating a selected leaf node). The calculation result obtained by the external computing device through calculation is stored in the storage. The host CPU obtains the calculation result from the storage, and performs a subsequent query operation based on the calculation result. The external computing device is configured to accelerate output of a target position of a key in a mapping unit by a learned index model. The external computing device may be a device having computing power, for example, a programmable switch, an intelligent network interface card, and an intelligent chip, so that a part of computing in a query process can be offloaded to the external computing device, to improve query efficiency. The intelligent chip includes, for example, a graphics processing unit (graphics processing unit, GPU), a tensor processing unit (tensor processing unit, TPU), a neural network processing unit (Neural network Processing Unit, NPU), or a data processing unit (Data Processing Unit, DPU). When processing batch query requests, the external computing device can process multiple query requests in parallel, thereby greatly improving query efficiency in a batch query request scenario. Specifically, the external computing device includes multiple computing units. The computing unit is, for example, a multiply-accumulator (multiple accumulator, MAC) or a matrix computing unit. The plurality of computing units may process query requests in parallel, so that a throughput of batch query processing can be increased.

The storage may be a high-speed storage, for example, a volatile storage or a non-volatile storage. The storage may be specifically a double rate (Double Data Rate, DDR) synchronous dynamic random access memory (Synchronous Dynamic Random Access Memory, SDRAM), a high bandwidth memory (High Bandwidth Memory, HBM), or the like.

The learned index model may be fully stored in a storage corresponding to the external computing device. When processing a query request, the external computing device runs a target learned index model corresponding to a data group to which to-be-operated data belongs, uses a target key corresponding to the to-be-operated data as an input of the target learned index model, and outputs a target position corresponding to the key to the storage.

In another implementation, a part (for example, a root model and/or an intermediate model) of the learned index model is stored in a storage of the external computing device. When processing a query request, the external computing device runs a part of a target learned index model corresponding to a data group to which to-be-operated data belongs, uses a target key corresponding to the to-be-operated data as an input of the part of the model, and outputs a selected intermediate model or leaf model to the storage.

Optionally, product quantization of data may also be performed by the external computing device, to accelerate output of a short code vector.

The mapping unit is, for example, stored in the storage on the host side. After obtaining the target position from the storage, the host CPU obtains a pointer corresponding to the target position. If only a mapping relationship between the target key and one pointer is stored at the target position, and the pointer indicates only a storage position of one piece of data, the host CPU may return the target data corresponding to the pointer. If mapping relationships between the target key and multiple pointers are stored at the target position, the host CPU calculates distances between data corresponding to the multiple pointers and the to-be-operated data, and returns data that has a smallest distance from the to-be-operated data.

The foregoing external computing device is an optional device, that is, product quantization of data, index query, and the like are all implemented by the host CPU. This is not limited herein.

FIG. 7 is a schematic flowchart of a data processing method according to this application. The method is performed by the foregoing data processing system. The method includes the following steps.

S701: Obtain an operation request, where the operation request includes an operation instruction and to-be-operated data.

The operation request includes the operation instruction and the to-be-operated data. The operation instruction is, for example, a query instruction, an insert instruction, an update instruction, or a delete instruction. The operation request may be a batch operation request, or may be an independent operation request.

S702: Perform product quantization encoding on a target residual value or the to-be-operated data to obtain a target key, where the target residual value is a residual value between the to-be-operated data and a centric vector of a target data group, each data group includes data aggregated through clustering, and K is an integer greater than or equal to 1.

When a PQ codebook is obtained through training based on the residual value, a short code vector obtained by performing PQ encoding on the target residual value is used as the target key. The target residual value is the residual value between the to-be-operated data and the centric vector of the target data group, and the target data group is a data group to which the to-be-operated data belongs in K data groups. Each data group includes approximate data aggregated by using a clustering algorithm. For clustering and PQ encoding for the data group, refer to the foregoing related descriptions. Details are not described herein again.

When the PQ codebook is obtained through training based on original data, a short code vector obtained by performing PQ encoding on the to-be-operated data is used as the target key.

S703: Execute the operation instruction based on the target key and a target learned index corresponding to the target data group.

In this embodiment, data in a data set is clustered, and approximate data is clustered into a same data group, to train a corresponding learned index for each data group, so as to improve index precision and performance. For training and a structure of the learned index, refer to the foregoing related descriptions. Details are not described herein again.

When data query is involved, a learned index corresponding to the target data group to which the to-be-operated data belongs is the target learned index. The target key is used as an input of the target learned index, and the target learned index outputs a pointer that indicates a storage position of target data corresponding to the to-be-operated data. When a data change is involved, a new key-pointer pair is obtained, and the target learned index needs to be updated with the new key-pointer pair.

The following separately describes how to execute the operation instruction when the operation request is a query request, an insert request, an update request, or a delete request.

### 1. The operation request is a query request.

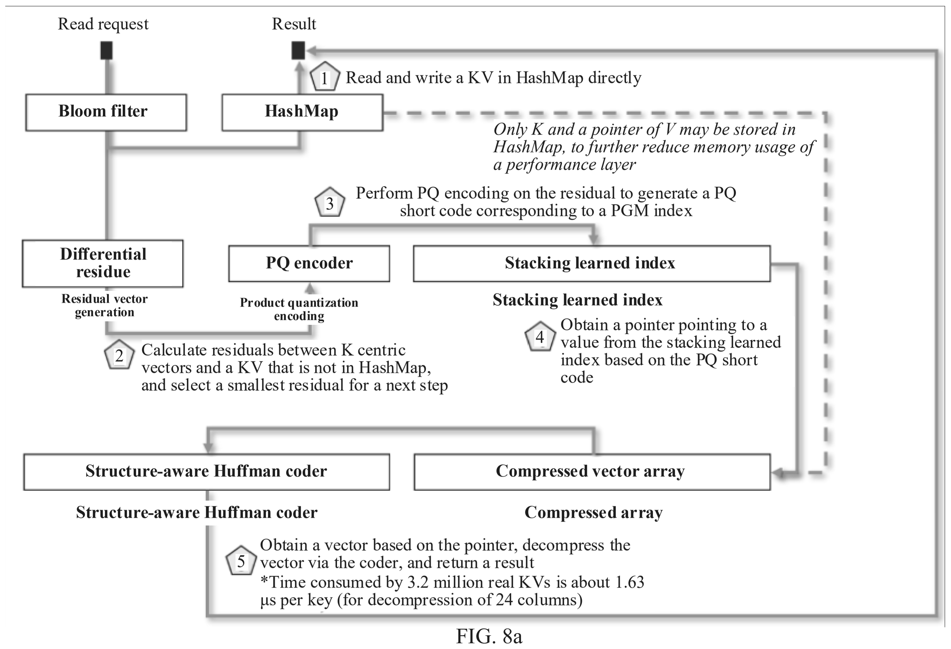

As shown in FIG. 8a, for to-be-operated data, after a corresponding target key is obtained, the target key is used as an input of a target learned index, to obtain a first pointer output by the target learned index. Then, target data is obtained based on the pointer. When the first pointer includes multiple pointers, candidate data indicated by each pointer is obtained, a distance between each piece of candidate data and the to-be-operated data is calculated, and candidate data with a smallest distance is determined as the target data. When the first pointer is one pointer, and the pointer indicates a storage position of only one piece of data, data obtained based on the first pointer is the target data. When the first pointer is one pointer, and there are multiple pieces of candidate data at a storage position indicated by the pointer, a distance between each piece of candidate data and the to-be-operated data is calculated, and candidate data with a smallest distance is determined as the target data.

If the target data is stored in a storage medium as compressed target data after compression, the compressed target data needs to be decompressed. Specifically, when the first pointer indicates a storage position of multiple pieces of candidate data in a compressed state, the candidate data in the compressed state needs to be decompressed, then a distance between decompressed candidate data and the to-be-operated data is calculated, and candidate data nearest to the to-be-operated data is determined as the target data. When the first pointer indicates a storage position of only one piece of data in a compressed state (namely, compressed target data), the compressed target data is read and decompressed into uncompressed target data. For a decompression method, refer to the foregoing related descriptions. Details are not described herein again.

### 2. The operation request is an update request.

In an implementation, for to-be-operated data, after a corresponding target key is obtained, the target key is used as an input of a target learned index, to obtain a pointer output by the target learned index. Then, data at a storage position indicated by the pointer output by the target learned index is updated using the to-be-operated data. In this case, the target learned index does not need to be modified.

In an implementation, the to-be-operated data is written at a blank position in a storage medium through appending (append), to obtain a mapping relationship between the target key and a second pointer that indicates the position at which the to-be-operated data is written. Then, a mapping relationship between the target key and an original pointer in the target learned index is modified to the mapping relationship between the target key and the second pointer. In this application, the target learned index includes a target learned index model and a mapping unit, the target learned index model learns a distribution rule of target keys in the mapping unit, and actual data distribution in the storage medium is decoupled from the target learned index model. In this case, when data is written into the storage medium, whether writing of the data affects the data distribution rule in the storage medium may not be considered, and the data may be written into the storage medium through appending, so that write performance can be improved.

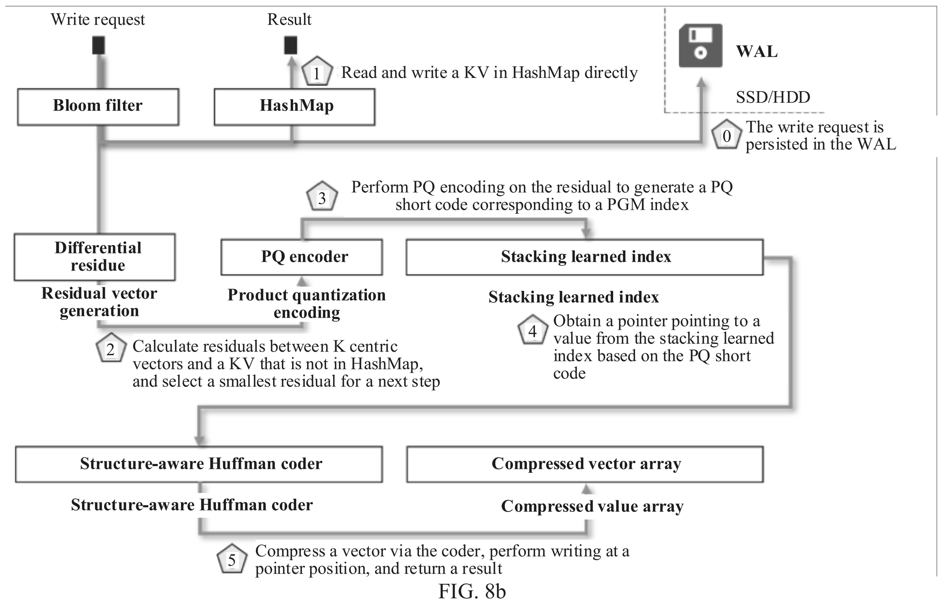

As shown in FIG. 8b, if data is stored in a storage medium in a compressed state, after a corresponding target key is obtained, the target key is used as an input of a target learned index, to obtain a pointer output by the target learned index. Then, a length of first compressed data corresponding to the pointer output by the target learned index is compared with a length of second compressed data corresponding to to-be-operated data. If the length of the first compressed data is greater than or equal to that of the second compressed data, the first compressed data is replaced with the second compressed data at a position indicated by the pointer output by the target learned index. If the length of the first compressed data is less than that of the second compressed data, the second compressed data is written at a blank position in the storage medium, to obtain a mapping relationship between the target key and a second pointer that indicates the position at which the second compressed data is written. Then, a mapping relationship between the target key and an original pointer in the target learned index is modified to the mapping relationship between the target key and the second pointer. For a method for compressing the to-be-operated data to obtain the second compressed data, refer to the foregoing related descriptions. Details are not described herein again.

### 3. The operation request is an insert request.

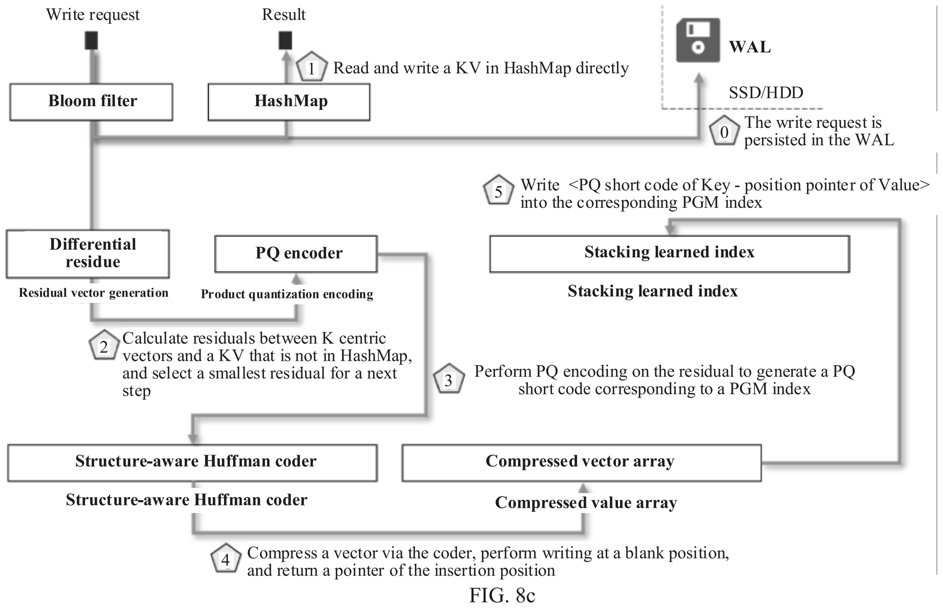

As shown in FIG. 8c, to-be-operated data is written into a storage medium through appending, to obtain a third pointer that indicates a storage position of the to-be-operated data in the storage medium. Then, a mapping relationship between a target key and the third pointer is inserted into a target learned index, so that the corresponding pointer can be obtained through the target learned index when the to-be-operated data is subsequently queried. Specifically, the mapping relationship between the target key and the third pointer is inserted into a mapping unit of the target learned index based on a ranking of the target key, to ensure orderly distribution of keys in the mapping unit, and ensure accuracy of a position that is of the target key in the mapping unit and that is output by a target learned index model based on the target key. Because the target key corresponding to the to-be-operated data does not exist before, the target learned index model in the target learned index does not learn a mapping relationship between the target key and the position of the target key in the mapping unit. To improve prediction accuracy of the target learned index model, the target learned index model may be retrained after the mapping relationship between the target key and the third pointer is obtained, or the target learned index model may be retrained after a period of time or after a specific quantity of mapping relationships are accumulated and inserted.

Optionally, compressed data obtained by encoding and compressing the to-be-operated data may be written into the storage medium, and a third pointer that indicates a storage position of the compressed data corresponding to the to-be-operated data is obtained. In this case, the third pointer may be an ID allocated to the compressed data corresponding to the to-be-operated data, or may be a position, in a compression header, at which start position information of the compressed data is stored.

### 4. The operation request is a delete request.

Target data corresponding to to-be-operated data is deleted, and a mapping relationship between a target key and a pointer that indicates a storage position of the target data no longer exists. Therefore, the mapping relationship needs to be deleted from a mapping unit of a target learned index. Only the mapping relationship between the target key and the pointer that indicates the storage position of the target data may be deleted, so that the target data cannot be queried. Alternatively, the target data in the storage medium may be further deleted. Specifically, after the target key corresponding to the to-be-operated data is obtained, the target key is used as an input of the target learned index, to obtain a pointer output by the target learned index. If the target key is associated with only one piece of data, the data at a storage position indicated by the pointer output by the target learned index is deleted. If the target key is associated with multiple pieces of candidate data, candidate data nearest to the to-be-operated data is deleted from the pieces of candidate data.

Optionally, before S702, an existence test may be performed through a Bloom filter, to check whether the to-be-operated data exists in a memory. If the to-be-operated data exists in the memory, a read operation (a query request) or a write operation (an insert request or an update request) of the to-be-operated data is directly completed based on a mapping relationship between to-be-operated data and a pointer in a Hash map of the memory. If the write operation is involved, a corresponding write-ahead log is generated, and the write-ahead log is persisted. If the to-be-operated data does not exist in the memory, S702 and S703 are performed.

In this embodiment, the short code vector is obtained by performing PQ encoding on the to-be-operated data. Dimensions of the data are reduced, costs of training and prediction of the learned index can be reduced, and prediction performance can be improved. Through the learned index model, a position of a key in the mapping unit can be quickly and accurately located, and the position of the key in the mapping unit does not need to be determined in a manner such as traversal or binary search. The mapping unit stores a mapping relationship between a key and a pointer corresponding to data. A pointer having a mapping relationship with a key may be obtained based on a position of the key, and the pointer directly or indirectly indicates a storage position of data, so that a precise storage position of the data can be obtained. When data is stored in the storage medium in a form of compressed data, start position information of each piece of compressed data is recorded in the compression header, so that any compressed data can be randomly read, and all other irrelevant data does not need to be read and decompressed together. This can reduce write amplification and improve read performance of the compressed data. In addition, in this embodiment, data is segmented and compressed based on a data structure. This can improve a compression ratio of the data, further reduce a storage space occupied for data storage, and improve utilization of the storage medium.

It should be noted that S701 to S703 may be all performed by a host CPU on a host side. Optionally, S702 may alternatively be performed by an external computing device. Optionally, the operation of obtaining, through the target learned index based on the target key, the pointer corresponding to the target key in S703 may alternatively be performed by the external computing device, to accelerate a query rate.

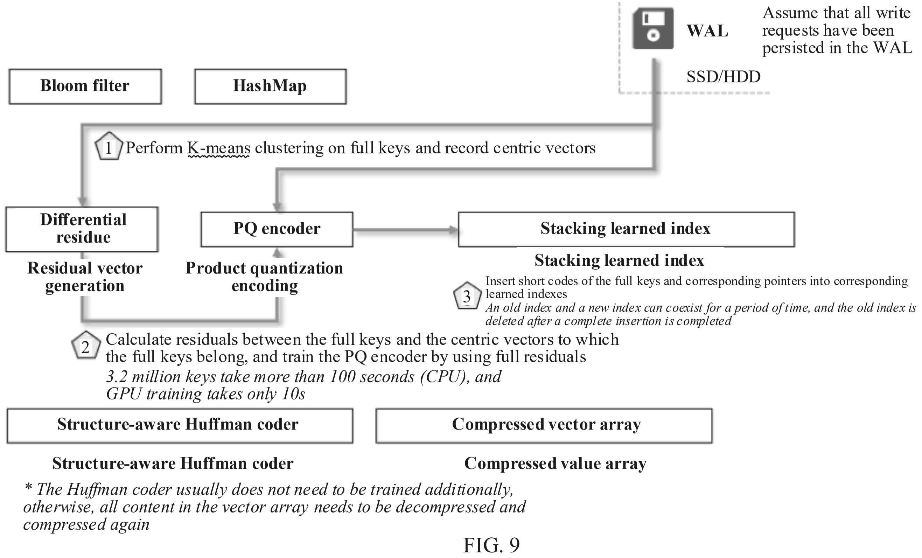

Optionally, as shown in FIG. 9, when a data distribution difference between data groups satisfies a condition, a data set may be retrained. Re-clustering is performed in the data set to obtain K updated data groups, and a learned index corresponding to each updated data group is updated. That the data distribution difference between the data groups satisfies the condition may mean that a difference between quantities of elements in different data groups exceeds a threshold, or a mean square error of the quantities of elements in the different data groups exceeds a threshold.

To verify a technical effect of this solution, a test is performed based on the solution provided in this application. Test results in different scenarios are provided below.

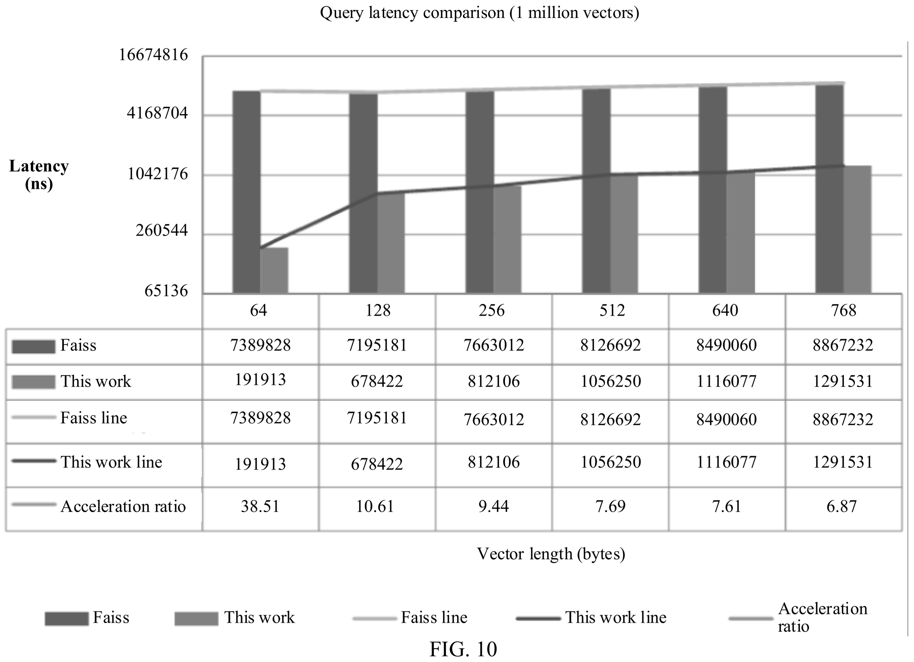

FIG. 10 shows a comparison between query performance of this solution and that of an existing solution in terms of a query of 1 million vectors in a structured data database storage scenario. It can be learned that the query performance is improved by 6x to 38x (times), and accuracy is also improved.

In addition, completing a query operation based on collaboration of a GPU and a CPU is compared with completing the query operation based only on the CPU, and an experiment result shows that an index search throughput is accelerated by 150x to 700x when a GPU V100 is used, and the index search throughput is accelerated by 975x to 2800x when a GPU A100 is used.

It can be learned that index storage overheads and search performance can be optimized through a learned index. The query throughput can be further accelerated by using diversified computing power like a GPU.

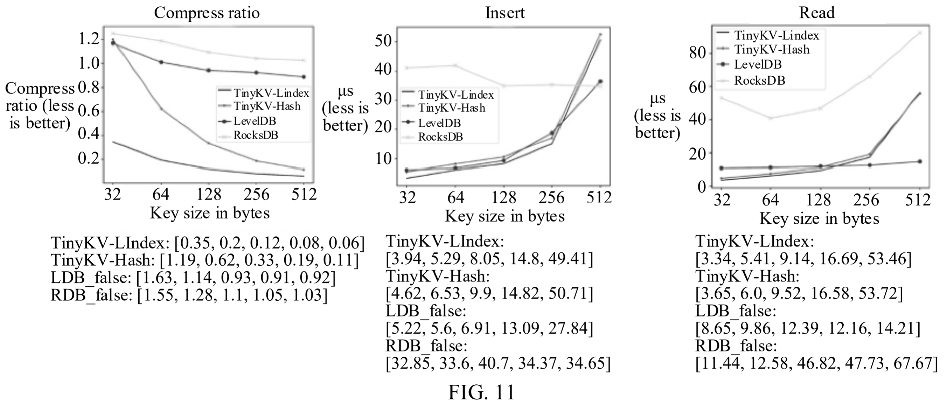

In a fingerprint table storage scenario, as shown in FIG. 11, an overall compression effect of a product data set reaches 2x. Average access latency of TinyKV based on a learned index is less than 6.27 µs, is reduced by 44.12% compared with that of LevelDB, and is reduced by 84.68% compared with that of RocksDB.

Index storage overheads and search performance can be optimized through the learned index. Structured compression is performed on approximate values in value information, to optimize storage performance. Storage overheads of structured data are optimized by using a structure-aware data compression method.

In conclusion, in a scale of 1 million vectors, the average access latency is less than 6.27 µs, is reduced by 44.12% compared with that of LevelDB, and is reduced by 84.68% compared with that of RocksDB; and an index size is reduced by 78.5% to 93.5% compared with that of LevelDB, and is reduced by 77.4% to 94.2% compared that of with RocksDB. Longer structured data indicates a higher reduction rate of TinyKV. In a test on the GPU V100, the query throughput is improved by 150x to 700x.

The following table shows a compression test of a structured compression algorithm based on approximate structured data provided in this application. In a test on a metadata set, a compression ratio reaches 4.5x to 5.9x. Compression performance reaches 994.5 MB/s on x86 and 503 MB/s on ARM. Decompression performance reaches 1443.9 MB/s on x86 and 1158.8 MB/s on ARM. The performance is improved by more than 10x compared with that in zstd.

| Indicator | Product requirement | x86 | ARM |
|---|---|---|---|
| Compression ratio | 2.65 | The compression ratio reaches 4.5x to 5.9x | |
| Compression performance | 500 MB/s | 994.5 MB/s | 503 MB/s |
| Decompression performance | 1000 MB/s | 1443.9 MB/s | *1158.8* MB/s |

The compression ratio issue is resolved through approximate data partitioning. The performance issue is resolved by using SIMD instructions. Random access to metadata is supported, to resolve the read amplification problem. The compression method provided by this application has high performance and a high compression ratio, and supports random access, to avoid a performance bottleneck caused by read amplification.

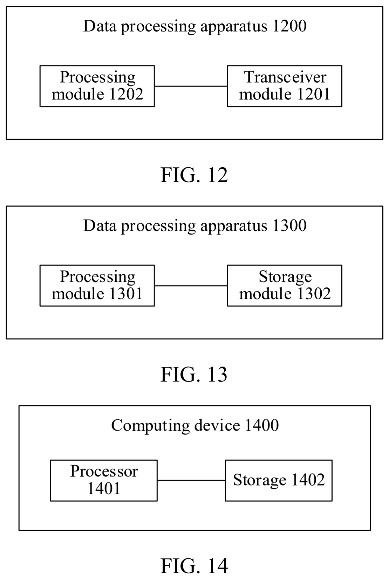

Based on a same inventive concept, this application further provides a corresponding apparatus embodiment. FIG. 12 is a diagram of a structure of a data processing apparatus according to this application. The apparatus 1200 includes: a transceiver module 1201, configured to obtain an operation request, where the operation request includes an operation instruction and to-be-operated data; a processing module 1202, configured to perform product quantization encoding on a target residual value or the to-be-operated data to obtain a target key, where the target residual value is a residual value between the to-be-operated data and a centric vector of a target data group, the target data group is a data group to which the to-be-operated data belongs in K data groups, and K is an integer greater than or equal to 1; and the processing module 1202 is configured to execute the operation instruction based on the target key and a target learned index corresponding to the target data group.

In a possible implementation, the target learned index is used to output, based on the target key, a pointer corresponding to the to-be-operated data, the target learned index includes a learned index model and a mapping unit, the learned index model is used to output, based on the target key, a target position of the target key in the mapping unit, and a mapping relationship between the target key and the pointer corresponding to the to-be-operated data is stored at the target position.

In a possible implementation, a target learned index model includes a root model, at least two intermediate models, and at least two leaf models, the root model is used to select a target intermediate model from the at least two intermediate models based on the target key, the target intermediate model is used to select a target leaf model from the at least two leaf models, the target leaf model is used to output the target position based on the target key, and the target leaf model is a non-linear function.

In a possible implementation, at least a part of the learned index model is stored in a storage corresponding to an external computing device, and the external computing device is configured to obtain the target intermediate model, the target leaf module, or the target position based on the at least part of the model.

In a possible implementation, the operation instruction is a query instruction, and the query instruction instructs to read target data corresponding to the to-be-operated data; the processing module 1202 is configured to obtain a first pointer through the target learned index based on the target key, where the first pointer indicates a storage position of the target data; and the processing module 1202 is configured to obtain the target data based on the first pointer, where when the first pointer is associated with one piece of data, the target data is the data associated with the first pointer; or when the first pointer is associated with multiple pieces of data, the target data is data that has a smallest distance from the to-be-operated data in the multiple pieces of data associated with the first pointer.

In a possible implementation, the target data is stored as compressed target data after compression; the processing module 1202 is configured to obtain the compressed target data based on the first pointer; and the processing module 1202 is configured to decompress the compressed target data via a decoder, to obtain the target data, where the target data is structured data, the target data includes N data segments obtained through division based on an attribute, the compressed target data includes N compressed data segments, the N compressed data segments are obtained by compressing the N data segments via M sub-encoders of an encoder, each of the sub-encoders is configured to encode at least one data segment corresponding to one attribute, the decoder includes M sub-decoders, the M sub-decoders are in one-to-one correspondence with the M sub-encoders, and each of the sub-decoders is configured to decode at least one of the N compressed data segments.

In a possible implementation, the operation instruction is an update instruction; the processing module 1202 is configured to write the to-be-operated data into a storage medium; and the processing module 1202 is configured to update the target learned index with a mapping relationship between the target key and a second pointer, where the second pointer indicates a storage position of the to-be-operated data in the storage medium.

In a possible implementation, the operation instruction is an insert instruction; the processing module 1202 is configured to write the to-be-operated data into a storage medium; and the processing module 1202 is configured to insert a mapping relationship between the target key and a third pointer into the target learned index, where the third pointer indicates a storage position of the to-be-operated data in the storage medium.

In a possible implementation, the processing module 1202 is specifically configured to encode and compress the to-be-operated data via an encoder corresponding to the target data group, to obtain compressed data, where the to-be-operated data is structured data, the to-be-operated data includes N data segments obtained through division based on an attribute, the compressed data includes N compressed data segments, the N compressed data segments are obtained by encoding and compressing the N data segments via M sub-encoders of the encoder, and each of the sub-encoders is configured to encode at least one data segment corresponding to one attribute; and the processing module 1202 is specifically configured to write the compressed data into the storage medium.

In a possible implementation, the operation instruction is a delete instruction; the processing module 1202 is configured to obtain, through the target learned index based on the target key, a fourth pointer indicating a storage position of target data corresponding to the to-be-operated data; the processing module 1202 is configured to delete data at the storage position indicated by the fourth pointer; and the processing module 1202 is configured to delete a mapping relationship between the target key and the fourth pointer from the target learned index.

In a possible implementation, the apparatus further includes: when data distribution in the K data groups satisfies a condition, performing re-clustering in a data set to obtain K updated data groups, and updating a learned index corresponding to each updated data group.

FIG. 13 is a diagram of a structure of a data processing apparatus according to this application. The apparatus 1300 includes: a processing module 1301, configured to obtain a target key, where the target key is obtained by performing product quantization encoding on to-be-operated data or a target residual value in an operation request, the target residual value is a residual value between the to-be-operated data and a centric vector of a target data group, the target data group is a data group to which the to-be-operated data belongs in K data groups, and K is an integer greater than or equal to 1; and the processing module 1301 is configured to obtain, based on the target key through a target learned index corresponding to the target data group, a pointer corresponding to the target key, where the pointer indicates a storage position of target data corresponding to the to-be-operated data.

In a possible implementation, the target learned index is used to output, based on the target key, a pointer corresponding to the to-be-operated data, the target learned index includes a learned index model and a mapping unit, the learned index model is used to output, based on the target key, a target position of the target key in the mapping unit, and a mapping relationship between the target key and the pointer corresponding to the to-be-operated data is stored at the target position.

A target learned index model learns a distribution rule of target keys in the mapping unit, and actual data distribution in a storage medium is decoupled from the target learned index model. In this case, when the data is written into the storage medium, whether the data writing affects a data distribution rule in the storage medium does not need to be considered. The data may be written into the storage medium through appending, so that write performance can be improved. In addition, during data query, a position of the target key in the mapping unit can be quickly hit through the target learned index model, so that a quantity of queries can be reduced. The mapping unit stores a mapping relationship between the target key and the pointer. A storage position of corresponding data can be accurately obtained, thereby improving query accuracy and efficiency.

In a possible implementation, a target learned index model includes a root model, at least two intermediate models, and at least two leaf models, the root model is used to select a target intermediate model from the at least two intermediate models based on the target key, the target intermediate model is used to select a target leaf model from the at least two leaf models, the target leaf model is used to output the target position based on the target key, and the target leaf model is a non-linear function. The non-linear function can better fit key distribution, to predict a position of a key more accurately.

In a possible implementation, the apparatus further includes a storage module 1302. The storage module is configured to store the target learned index model or a part of the target learned index model, so that during query, a corresponding pointer is obtained through the target learned index model based on the target key.

FIG. 14 is a diagram of a structure of a computing device according to this application. The computing device includes at least one processor 1401 and at least one storage 1402. The at least one storage 1402 stores computer-readable instructions. The at least one processor 1401 executes the computer-readable instructions, to cause the computing device to perform the method in any one of the foregoing embodiments.

This application provides a computer-readable storage medium. The computer-readable storage medium includes computer-readable instructions. The computer-readable instructions are used to implement the method in any one of the foregoing embodiments.

This application provides a computer program product, including computer-readable instructions. The computer-readable instructions are used to implement the method in any one of the foregoing embodiments.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in other manners. For example, the described apparatus embodiments are merely examples. For example, the unit division is merely logical function division and may be other division during actual implementation. For example, multiple units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic or other forms.

The units described as separate parts may or may not be physically separate, and parts displayed as units may or may not be physical units, may be located in one position, or may be distributed on multiple network units. A part or all of the units may be selected based on actual requirements to achieve the objectives of the solutions of embodiments.

In addition, functional units in embodiments of this application may be integrated into one processing unit, each of the units may exist alone physically, or two or more units may be integrated into one unit. The integrated unit may be implemented in a form of hardware, or may be implemented in a form of a software functional unit.

When the integrated unit is implemented in the form of the software functional unit and sold or used as an independent product, the integrated unit may be stored in a computer-readable storage medium. Based on such an understanding, all or a part of the technical solutions of this application may be implemented in a form of a software product. The computer software product is stored in a storage medium, and includes several instructions for instructing a computer device (which may be a personal computer, a server, a network device, or the like) to perform all or a part of the steps of the methods described in embodiments of this application. The foregoing storage medium includes any medium that can store program code, such as a USB flash drive, a removable hard disk, a read-only memory (ROM, read-only memory), a random access memory (RAM, random access memory), a magnetic disk, or an optical disc.

## Claims

1. A data processing method, wherein the method comprises:
obtaining an operation request, wherein the operation request comprises an operation instruction and to-be-operated data;
performing product quantization encoding on a target residual value or the to-be-operated data to obtain a target key, wherein the target residual value is a residual value between the to-be-operated data and a centric vector of a target data group, the target data group is a data group to which the to-be-operated data belongs in K data groups, and K is an integer greater than or equal to 1; and
executing the operation instruction based on the target key and a target learned index corresponding to the target data group.

2. The method according to claim 1, wherein the target learned index is used to output, based on the target key, a pointer corresponding to the to-be-operated data, the target learned index comprises a learned index model and a mapping unit, the learned index model is used to output, based on the target key, a target position of the target key in the mapping unit, and a mapping relationship between the target key and the pointer corresponding to the to-be-operated data is stored at the target position.

3. The method according to claim 2, wherein the target learned index model comprises a root model, at least two intermediate models, and at least two leaf models, the root model is used to select a target intermediate model from the at least two intermediate models based on the target key, the target intermediate model is used to select a target leaf model from the at least two leaf models, the target leaf model is used to output the target position based on the target key, and the target leaf model is a non-linear function.

4. The method according to claim 2 or 3, wherein at least a part of the learned index model is stored in a storage corresponding to an external computing device, and the external computing device is configured to obtain the target intermediate model, the target leaf module, or the target position based on the at least part of the model.

5. The method according to any one of claims 1 to 4, wherein the operation instruction is a query instruction, the query instruction instructs to read target data corresponding to the to-be-operated data, and the executing the operation instruction based on the target key and the target learned index corresponding to the target data group comprises:
obtaining a first pointer through the target learned index based on the target key, wherein the first pointer indicates a storage position of the target data; and
obtaining the target data based on the first pointer, wherein when the first pointer is associated with one piece of data, the target data is the data associated with the first pointer; or when the first pointer is associated with multiple pieces of data, the target data is data that has a smallest distance from the to-be-operated data in the multiple pieces of data associated with the first pointer.

6. The method according to claim 5, wherein the target data is stored as compressed target data after compression, and the obtaining the target data based on the first pointer comprises:
obtaining the compressed target data based on the first pointer; and
decompressing the compressed target data via a decoder, to obtain the target data, wherein the target data is structured data, the target data comprises N data segments obtained through division based on an attribute, the compressed target data comprises N compressed data segments, the N compressed data segments are obtained by compressing the N data segments via M sub-encoders of an encoder, each of the sub-encoders is configured to encode at least one data segment corresponding to one attribute, the decoder comprises M sub-decoders, the M sub-decoders are in one-to-one correspondence with the M sub-encoders, each of the sub-decoders is configured to decode at least one of the N compressed data segments, and both M and N are integers greater than or equal to 1.

7. The method according to any one of claims 1 to 4, wherein the operation instruction is an update instruction, and the executing the operation instruction based on the target key and the target learned index corresponding to the target data group comprises:
writing the to-be-operated data into a storage medium; and
updating the target learned index with a mapping relationship between the target key and a second pointer, wherein the second pointer indicates a storage position of the to-be-operated data in the storage medium.

8. The method according to any one of claims 1 to 4, wherein the operation instruction is an insert instruction, and the executing the operation instruction based on the target key and the target learned index corresponding to the target data group comprises:
writing the to-be-operated data into a storage medium; and
inserting a mapping relationship between the target key and a third pointer into the target learned index, wherein the third pointer indicates a storage position of the to-be-operated data in the storage medium.

9. The method according to claim 7 or 8, wherein the writing the to-be-operated data into the storage medium comprises:
encoding and compressing the to-be-operated data via an encoder corresponding to the target data group, to obtain compressed data, wherein the to-be-operated data is structured data, the to-be-operated data comprises N data segments obtained through division based on an attribute, the compressed data comprises N compressed data segments, the N compressed data segments are obtained by encoding and compressing the N data segments via M sub-encoders of the encoder, each of the sub-encoders is configured to encode at least one data segment corresponding to one attribute, and both M and N are integers greater than or equal to 1; and
writing the compressed data into the storage medium.

10. The method according to any one of claims 1 to 4, wherein the operation instruction is a delete instruction, and the executing the operation instruction based on the target key and the target learned index corresponding to the target data group comprises:
obtaining, through the target learned index based on the target key, a fourth pointer indicating a storage position of target data corresponding to the to-be-operated data;
deleting data at the storage position indicated by the fourth pointer; and
deleting a mapping relationship between the target key and the fourth pointer from the target learned index.

11. The method according to any one of claims 1 to 10, wherein the method further comprises:
when data distribution in the K data groups satisfies a condition, performing re-clustering in a data set to obtain K updated data groups, and updating a learned index corresponding to each updated data group.

12. A data processing method, wherein the method comprises:
obtaining a target key, wherein the target key is obtained by performing product quantization encoding on to-be-operated data or a target residual value in an operation request, the target residual value is a residual value between the to-be-operated data and a centric vector of the target data group, the target data group is a data group to which the to-be-operated data belongs in K data groups, and K is an integer greater than or equal to 1; and
obtaining, based on the target key through a target learned index corresponding to the target data group, a pointer corresponding to the target key, wherein the pointer indicates a storage position of target data corresponding to the to-be-operated data.

13. A data processing apparatus, wherein the apparatus comprises:
a transceiver module, configured to obtain an operation request, wherein the operation request comprises an operation instruction and to-be-operated data; and
a processing module, configured to perform product quantization encoding on a target residual value or the to-be-operated data to obtain a target key, wherein the target residual value is a residual value between the to-be-operated data and a centric vector of a target data group, the target data group is a data group to which the to-be-operated data belongs in K data groups, and K is an integer greater than or equal to 1; and
the processing module is configured to execute the operation instruction based on the target key and a target learned index corresponding to the target data group.

14. The apparatus according to claim 13, wherein the target learned index is used to output, based on the target key, a pointer corresponding to the to-be-operated data, the target learned index comprises a learned index model and a mapping unit, the learned index model is used to output, based on the target key, a target position of the target key in the mapping unit, and a mapping relationship between the target key and the pointer corresponding to the to-be-operated data is stored at the target position.

15. The apparatus according to claim 14, wherein the target learned index model comprises a root model, at least two intermediate models, and at least two leaf models, the root model is used to select a target intermediate model from the at least two intermediate models based on the target key, the target intermediate model is used to select a target leaf model from the at least two leaf models, the target leaf model is used to output the target position based on the target key, and the target leaf model is a non-linear function.

16. The apparatus according to claim 14 or 15, wherein at least a part of the learned index model is stored in a storage corresponding to an external computing device, and the external computing device is configured to obtain the target intermediate model, the target leaf module, or the target position based on the at least part of the model.

17. The apparatus according to any one of claims 13 to 16, wherein the operation instruction is a query instruction, and the query instruction instructs to read target data corresponding to the to-be-operated data;
the processing module is configured to obtain a first pointer through the target learned index based on the target key, wherein the first pointer indicates a storage position of the target data; and
the processing module is configured to obtain the target data based on the first pointer, wherein when the first pointer is associated with one piece of data, the target data is the data associated with the first pointer; or when the first pointer is associated with multiple pieces of data, the target data is data that has a smallest distance from the to-be-operated data in the multiple pieces of data associated with the first pointer.

18. The apparatus according to claim 17, wherein the target data is stored as compressed target data after compression;
the processing module is configured to obtain the compressed target data based on the first pointer; and
the processing module is configured to decompress the compressed target data via a decoder, to obtain the target data, wherein the target data is structured data, the target data comprises N data segments obtained through division based on an attribute, the compressed target data comprises N compressed data segments, the N compressed data segments are obtained by compressing the N data segments via M sub-encoders of an encoder, each of the sub-encoders is configured to encode at least one data segment corresponding to one attribute, the decoder comprises M sub-decoders, the M sub-decoders are in one-to-one correspondence with the M sub-encoders, each of the sub-decoders is configured to decode at least one of the N compressed data segments, and both M and N are integers greater than or equal to 1.

19. The apparatus according to any one of claims 13 to 16, wherein the operation instruction is an update instruction;
the processing module is configured to write the to-be-operated data into a storage medium; and
the processing module is configured to update the target learned index with a mapping relationship between the target key and a second pointer, wherein the second pointer indicates a storage position of the to-be-operated data in the storage medium.

20. The apparatus according to any one of claims 13 to 16, wherein the operation instruction is an insert instruction;
the processing module is configured to write the to-be-operated data into a storage medium; and
the processing module is configured to insert a mapping relationship between the target key and a third pointer into the target learned index, wherein the third pointer indicates a storage position of the to-be-operated data in the storage medium.

21. The apparatus according to claim 19 or 20, wherein
the processing module is specifically configured to encode and compress the to-be-operated data via an encoder corresponding to the target data group, to obtain compressed data, wherein the to-be-operated data is structured data, the to-be-operated data comprises N data segments obtained through division based on an attribute, the compressed data comprises N compressed data segments, the N compressed data segments are obtained by encoding and compressing the N data segments via M sub-encoders of the encoder, each of the sub-encoders is configured to encode at least one data segment corresponding to one attribute, and both M and N are integers greater than or equal to 1; and
the processing module is specifically configured to write the compressed data into the storage medium.

22. The apparatus according to any one of claims 13 to 16, wherein the operation instruction is a delete instruction;
the processing module is configured to obtain, through the target learned index based on the target key, a fourth pointer indicating a storage position of target data corresponding to the to-be-operated data;
the processing module is configured to delete data at the storage position indicated by the fourth pointer; and
the processing module is configured to delete a mapping relationship between the target key and the fourth pointer from the target learned index.

23. The apparatus according to any one of claims 13 to 22, wherein the apparatus further comprises:
when data distribution in the K data groups satisfies a condition, performing re-clustering in a data set to obtain K updated data groups, and updating a learned index corresponding to each updated data group.

24. A data processing apparatus, wherein the apparatus comprises:
a processing module, configured to obtain a target key, wherein the target key is obtained by performing product quantization encoding on to-be-operated data or a target residual value in an operation request, the target residual value is a residual value between the to-be-operated data and a centric vector of the target data group, the target data group is a data group to which the to-be-operated data belongs in K data groups, and K is an integer greater than or equal to 1; and
the processing module is configured to obtain, based on the target key through a target learned index corresponding to the target data group, a pointer corresponding to the target key, wherein the pointer indicates a storage position of target data corresponding to the to-be-operated data.

25. A computing device, wherein the computing device comprises at least one processor and at least one storage, the at least one storage stores computer-readable instructions, and the at least one processor executes the computer-readable instructions, to cause the computing device to perform the method according to any one of claims 1 to 12.

26. A computer-readable storage medium, comprising computer-readable instructions, wherein the computer-readable instructions are used to implement the method according to any one of claims 1 to 12.

27. A computer program product, comprising computer-readable instructions, wherein the computer-readable instructions are used to implement the method according to any one of claims 1 to 12.
